# EUROPEAN PATENT SPECIFICATION

(11) **EP 2 953 439 B1**
(45) Date of publication and mention of the grant of the patent: **04.08.2021**
(21) Application number: 15170524.1
(22) Date of filing: 03.06.2015
(51) Int. Cl.: H05K 13/08, H05K 13/04, H05K 13/02

(54) **ELECTRONIC COMPONENT MOUNTING SYSTEM AND ELECTRONIC COMPONENT MOUNTING METHOD**
MONTAGESYSTEM FÜR ELEKTRONISCHE KOMPONENTE UND MONTAGEVERFAHREN FÜR ELEKTRONISCHE KOMPONENTE
STRUCTURE DE MONTAGE DE COMPOSANT ÉLECTRONIQUE ET PROCÉDÉ DE MONTAGE D'UN TEL COMPOSANT

(30) Priority: 04.06.2014 JP 2014116296
(43) Date of publication of application: 09.12.2015
(73) Proprietor: JUKI Corporation, Tama-shi, Tokyo 206-8551 (JP)
(72) Inventor: Miyamoto, Tetsurou, Tokyo, 206-8551 (JP)
(74) Representative: Hoeger, Stellrecht & Partner Patentanwälte mbB

(56) References cited:
- EP-A1- 1 227 712
- WO-A1-99/13428
- JP-A- 2011 054 711
- JP-B2- 4 135 445
- None

## Description

### BACKGROUND

### TECHNICAL FIELD

The present invention relates to an electronic component mounting system as defined in the preamble of claim 1 and an electronic component mounting method as defined in the preamble of claim 7.

### RELATED ART

An electronic component mounting system including a supplying device and a mounting apparatus, designated as a mounter, for mounting an electronic component supplied from the supplying device on a substrate is known. As the supplying device, a type of device supplying an electronic component held on a tape, as disclosed in, for example, Japanese Patent No. 4135445 and Japanese Patent Laid-Open No. 2002-299899, is known.

Such a supplying device includes a supplier designated as a feeder, and a reel around which a tape holding electronic components is wound is supported on the feeder.

In order to identify an electronic component, a reading operation for an identifier provided on the reel is performed. Through the reading operation, identification information for identifying the electronic component is acquired. On the basis of the identification information, it is determined whether or not the electronic component held on the feeder is an electronic component to be mounted on a substrate.

If the reading operation for an identifier is not properly performed due to, for example, a human error, there is a possibility that an electronic component not to be mounted may be mounted on a substrate. As a result, some of substrates produced by using the electronic component mounting system become defective products, which lowers the yield.

An apparatus and a method for monitoring the configuration of component feeders are described in WO 99/13428 A1. EP 1 227 712 A1 discloses a parts mounting apparatus and a parts checking method by the same. Further, an electronic component packaging device is known from JP 2011 054711 A.

### SUMMARY

An object of the present invention is to improve the production efficiency of an electronic component mounting system and an electronic component mounting method.

This object is solved by an electronic component mounting system as defined in claim 1.

Further preferred embodiments of the invention are defined in the dependent claims.

In the electronic component mounting system according to the present invention, the invalidation section can invalidate the operating device when the remaining number is zero.

The electronic component mounting system according to the present invention can further include a conversion section that converts the positive determination of the component collation section into the negative determination when the remaining number is zero.

The electronic component mounting system according to the present invention further includes a holding state sensor that detects a holding state of the holding member for the electronic component; a determination section that determines, on the basis of a detection result of the holding state sensor, whether or not the electronic component has been held by the holding member; and a retry count acquisition section that acquires retry count information corresponding to the number of retries of a holding action of the holding member performed when the determination section determines that the electronic component has not been held by the holding member, and the invalidation section can be able to invalidate the operating device if the remaining number is equal to or smaller than a first threshold value and the number of retries is equal to or larger than a second threshold value, and unable to invalidate the operating device if the remaining number is larger than the first threshold value.

The electronic component mounting system according to the present invention can further include a conversion section that converts the positive determination of the component collation section into the negative determination when the remaining number is equal to or smaller than the first threshold value and the number of retries is equal to or larger than the second threshold value.

In the electronic component mounting system according to the present invention, the control section can halt a mounting operation of the mounting apparatus when the determination result of the component collation section is a negative determination.

Further, as a second aspect, which is not part of the invention, an electronic component mounting systemis described, including a supplying device capable of supplying an electronic component; a mounting apparatus that includes a holding member for removably holding the electronic component and is capable of mounting the electronic component of the supplying device on a substrate by holding the electronic component with the holding member; an identification information acquisition section that acquires identification information for identifying the electronic component of the supplying device; a normal electronic component information acquisition section that acquires normal electronic component information corresponding to an electronic component to be mounted on the substrate; a component collation section that collates the identification information with the normal electronic component information to determine whether or not the electronic component of the supplying device is the electronic component to be mounted on the substrate; a control section that controls the mounting apparatus on the basis of a determination result of the component collation section; a remaining number information acquisition section that acquires remaining number information corresponding to the remaining number of electronic components in the supplying device; and a conversion section that converts a positive determination of the component collation section into a negative determination on the basis of the remaining number information, in which the control section halts a mounting operation of the mounting apparatus when the determination result of the component collation section is converted from the positive determination into the negative determination by the conversion section.

In the electronic component mounting system according to the second aspect, the conversion section can convert the positive determination into the negative determination when the remaining number is zero.

The electronic component mounting system according to the second aspect can further include a holding state sensor that detects a holding state of the holding member for the electronic component; a determination section that determines, on the basis of a detection result of the holding state sensor, whether or not the electronic component has been held by the holding member; and a retry count acquisition section that acquires retry count information corresponding to the number of retries of a holding action of the holding member performed when the determination section determines that the electronic component has not been held by the holding member, and the conversion section can be able to convert the positive determination into the negative determination if the remaining number is equal to or smaller than a first threshold value and the number of retries is equal to or larger than a second threshold value, and unable to convert the positive determination into the negative determination if the remaining number is larger than the first threshold value.

As a third aspect, which is not part of the invention, an electronic component mounting system is described including a supplying device that includes a feeder for supporting an electronic component and a feeder bank for supporting the feeder and is capable of supplying the electronic component; a mounting apparatus that includes a holding member for removably holding the electronic component and is capable of mounting the electronic component of the supplying device on a substrate by holding the electronic component with the holding member; an identification information acquisition section that acquires identification information for identifying the electronic component of the supplying device; a normal electronic component information acquisition section that acquires normal electronic component information corresponding to an electronic component to be mounted on the substrate; a component collation section that collates the identification information with the normal electronic component information to determine whether or not the electronic component of the supplying device is the electronic component to be mounted on the substrate; a control section that controls the mounting apparatus on the basis of a determination result of the component collation section; an operating device capable of generating an operation signal for converting a negative determination of the component collation section into a positive determination; a feeder detecting device that detects a connection state of the feeder to the mounting apparatus; and an invalidation section that invalidates the operating device on the basis of a detection result of the feeder detecting device.

The electronic component mounting system according to the third aspect can further include a conversion section that converts the positive determination of the component collation section into the negative determination when the feeder is in a non-connection state.

Further, an electronic component mounting system, which is not part of the invention, is described including a supplying device that includes a feeder for supporting an electronic component and a feeder bank for supporting the feeder and is capable of supplying the electronic component; a mounting apparatus that includes a holding member for removably holding the electronic component and is capable of mounting the electronic component of the supplying device on a substrate by holding the electronic component with the holding member; an identification information acquisition section that acquires identification information for identifying the electronic component of the supplying device; a normal electronic component information acquisition section that acquires normal electronic component information corresponding to an electronic component to be mounted on the substrate; a component collation section that collates the identification information with the normal electronic component information to determine whether or not the electronic component of the supplying device is the electronic component to be mounted on the substrate; a control section that controls the mounting apparatus on the basis of a determination result of the component collation section; a feeder detecting device that detects a connection state of the feeder to the mounting apparatus; and a conversion section that converts a positive determination of the component collation section into a negative determination on the basis of a detection result of the feeder detecting device, in which the control section halt a mounting operation of the mounting apparatus when the determination result of the component collation section is converted from the positive determination into the negative determination by the conversion section.

The above-mentioned object is solved by an electronic component mounting method as defined in claim 7.

Further, an electronic component mounting method, which is not part of the invention, is described including: performing collation of identification information for identifying an electronic component of a supplying device with normal electronic component information corresponding to an electronic component to be mounted on a substrate to make a determination whether or not the electronic component of the supplying device is the electronic component to be mounted on the substrate; mounting the electronic component supplied from the supplying device, on the basis of a result of the determination, by holding the electronic component with a holding member of a mounting apparatus; acquiring remaining number information corresponding to the remaining number of electronic components in the supplying device; and converting a positive determination of the collation into a negative determination based on the remaining number information, in which a mounting operation of the mounting apparatus is halted when the result of the determination is converted from the positive determination into the negative determination.

Further, an electronic component mounting method, which is not part of the invention, is described including: performing collation of identification information for identifying an electronic component of a supplying device, which includes a feeder for supporting the electronic component and a feeder bank for supporting the feeder, with normal electronic component information corresponding to an electronic component to be mounted on a substrate to make a determination whether or not the electronic component of the supplying device is the electronic component to be mounted on the substrate; mounting the electronic component supplied from the supplying device, on the basis of a result of the determination, by holding the electronic component with a holding member of a mounting apparatus; performing detection of a connection state of the feeder to the mounting apparatus; and invalidating an operating device capable of generating an operation signal for converting a negative determination of the collation into a positive determination on the basis of a result of the detection.

Further, an electronic component mounting method, which is not part of the invention, is described including: performing collation of identification information for identifying an electronic component of a supplying device, which includes a feeder for supporting the electronic component and a feeder bank for supporting the feeder, with normal electronic component information corresponding to an electronic component to be mounted on a substrate to make a determination whether or not the electronic component of the supplying device is the electronic component to be mounted on the substrate; mounting the electronic component supplied from the supplying device, on the basis of a result of the determination, by holding the electronic component with a holding member of a mounting apparatus; performing detection of a connection state of the feeder to the mounting apparatus; and converting a result of the determination from a positive determination into a negative determination on the basis of a result of the detection, in which a mounting operation of the mounting apparatus is halted when the result of the determination is converted from the positive determination into the negative determination.

According to the electronic component mounting system and the electronic component mounting method of the present invention, a defective substrate is difficult to occur.

### BRIEF DESCRIPTION OF THE DRAWINGS

FIG. 1 is a schematic diagram illustrating an example of an electronic component mounting system according to a first embodiment.
FIG. 2 is a perspective view illustrating an example of a mounting apparatus according to the first embodiment.
FIG. 3 is a schematic diagram illustrating an example of a feeder and a feeder bank according to the first embodiment.
FIG. 4 is a schematic diagram illustrating an example of a reel, the feeder and an attaching portion according to the first embodiment.
FIG. 5 is a diagram illustrating an example of a nozzle according to the first embodiment.
FIG. 6 is a functional block diagram illustrating an example of a control system according to the first embodiment.
FIG. 7 is a flowchart explaining an example of an electronic component mounting method according to the first embodiment.
FIG. 8 is a flowchart explaining another example of the electronic component mounting method according to the first embodiment.
FIG. 9 is a flowchart explaining an example of an electronic component mounting method according to a second embodiment.
FIG. 10 is a schematic diagram illustrating an example of an electric feeder.
FIG. 11 is a flowchart explaining an example of an electronic component mounting method.

### DETAILED DESCRIPTION

Preferred embodiments of the present invention will now be described with reference to the accompanying drawings, and it is noted that the present invention is not limited to these embodiments.

In the following description, an XYZ rectangular coordinate system is set, and positional relationships among respective elements will be described with reference to this XYZ rectangular coordinate system. One direction on a horizontal plane is defined as the X-axis direction, a direction perpendicular to the X-axis direction on the horizontal plane is defined as the Y-axis direction, and a direction (a vertical direction, an upward-downward direction) perpendicular to the X-axis direction and the Y-axis direction is defined as the Z-axis direction. Besides, rotation (inclination) directions around the X-axis, the Y-axis and the Z-axis are respectively defined as θX, θY and θZ directions. An XY plane is the horizontal plane. Each of an XZ plane and a YZ plane perpendicularly crosses the XY plane.

### <First Embodiment>

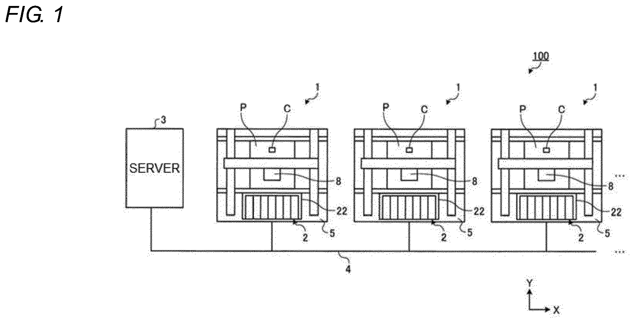

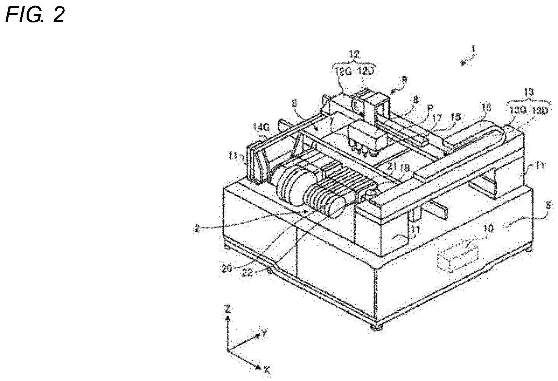

A first embodiment of the present invention will now be described. FIG. 1 is a schematic diagram of an example of an electronic component mounting system 100 according to the first embodiment. FIG. 2 is a perspective view of a mounting apparatus 1 according to the present embodiment.

As illustrated in FIG. 1, the electronic component mounting system 100 includes the mounting apparatus 1 mounting an electronic component C on a substrate P, and a server 3 managing the mounting apparatus 1. The mounting apparatus 1 includes a supplying device 2 capable of supplying an electronic component C, so as to mount the electronic component C of the supplying device 2 on a substrate P.

In the present embodiment, the electronic component mounting system 100 includes a plurality of mounting apparatuses 1. The supplying device 2 is provided in each of the plurality of mounting apparatuses 1. The server 3 is connected to the plurality of mounting apparatuses 1 via a cable 4 of a LAN cable or the like. The server 3 acquires information (signals) output from the mounting apparatuses 1 for managing the plurality of mounting apparatuses 1.

As illustrated in FIGS. 1 and 2, each mounting apparatus 1 includes a base member 5, a substrate moving device 6 provided on the base member 5 to be movable with a substrate P held thereon, a mounting head 8 including a nozzle (holding member) 7 removably holding an electronic component C for mounting, on a substrate P, the electronic component C of the supplying device 2 held by the nozzle 7, a mounting head moving device 9 provided on the base member 5 and capable of moving the mounting head 8, and a controller 10 for controlling the mounting apparatus 1. The controller 10 is connected to the server 3 through the cable 4.

The substrate moving device 6 can move the substrate P on the base member 5. The substrate moving device 6 includes a substrate holding section removably holding the rear surface (the bottom surface) of the substrate P, and an actuator generating power to move the substrate holding section. By the function of the actuator, the substrate P is moved while held by the substrate holding section. In the present embodiment, the substrate moving device 6 moves the substrate P in the X-axis direction. The substrate moving device 6 moves the substrate P from one end to the other end of the base member 5 along the X-axis direction.

Incidentally, the substrate moving device 6 may move the substrate P in the Y-axis direction or may move the substrate P in both the X-axis direction and the Y-axis direction. In other words, the substrate moving device 6 may be capable of moving the substrate P on the XY plane. Incidentally, the substrate moving device 6 may be capable of moving the substrate P in the six directions of the X-axis, Y-axis, Z-axis, θX, θY and θZ directions.

The mounting head 8 mounts the electronic component C supplied from the supplying device 2 on the surface (the top surface) of the substrate P held by the substrate holding section. The substrate P is moved by the substrate moving device 6 from one end to the other end of the base member 5 along the X-axis direction. The mounting head 8 mounts the electronic component C on the surface of the substrate P in a region between one end and the other end of the base member 5 along the X-axis direction.

The mounting head 8 includes the nozzle 7 removably holding the electronic component C. The mounting head 8 holds the electronic component C of the supplying device 2 to mount it on the substrate P. The nozzle 7 is provided on the mounting head 8 in a plural number. The plural nozzles 7 can be individually driven. In the present embodiment, each nozzle 7 is a suction nozzle for holding the electronic component C by suction. Each nozzle 7 has an opening provided at the tip, and an internal channel connected to the opening. A gas present in the internal channel of the nozzle 7 is sucked by an aspirator including a vacuum pump. When an aspiration operation of the nozzle 7 is performed with the tip of the nozzle 7 in contact with the electronic component C, the electronic component C is held by suction on the tip of the nozzle 7. When the aspiration operation of the nozzle 7 is cancelled, the electronic component C is released from the nozzle 7.

The mounting head moving device 9 can move the mounting head 8 above the substrate P. The mounting head moving device 9 moves the mounting head 8 within the XY plane.

The mounting head moving device 9 includes an X-axis driving unit 12 supporting the mounting head 8, a Y-axis driving unit 13 supporting the end on a +X side of the X-axis driving unit 12, and a guide member 14G supporting the end on a -X side of the X-axis driving unit 12. The Y-axis driving unit 13 and the guide member 14G are respectively supported by posts 11 provided on the base member 5. The X-axis driving unit 12 is supported by the Y-axis driving unit 13 and the guide member 14G.

The X-axis driving unit 12 includes a guide member 12G extending in the X-axis direction, and an actuator 12D generating power for moving the mounting head 8 in the X-axis direction. The guide member 12G guides the mounting head 8 in the X-axis direction. Owing to the function of the actuator 12D, the mounting head 8 is moved in the X-axis direction while supported by the guide member 12G.

The Y-axis driving unit 13 includes a guide member 13G extending in the Y-axis direction, and an actuator 13D generating power for moving the X-axis driving unit 12 in the Y-axis direction. The guide member 13G and the guide member 14G guide the X-axis driving unit 12 in the Y-axis direction. Owing to the function of the actuator 13D, the X-axis driving unit 12 is moved in the Y-axis direction while supported by the guide member 13G and the guide member 14G.

When the X-axis driving unit 12 is moved in the Y-axis direction by the Y-axis driving unit 13, the mounting head 8 supported by the X-axis driving unit 12 is moved in the Y-axis direction together with the X-axis driving unit 12. The mounting head 8 is moved in the X-axis direction owing to the function of the X-axis driving unit 12. Thus, the mounting head 8 can move within the XY plane above the substrate P.

The mounting head moving device 9 can move the mounting head 8 so that the nozzle 7 can be disposed in a mounting position (a loading position) opposing the surface (the top surface) of the substrate P and a supplying position (a transferring position) where the electronic component C is supplied from the supplying device 2. The nozzle 7 holds, in the supplying position, the electronic component C supplied from the supplying device 2. After holding the electronic component C in the supplying position, the nozzle 7 conveys it to the mounting position to load it on the substrate P. After loading the electronic component C on the substrate P in the mounting position, the nozzle 7 releases the electronic component C. In this manner, the electronic component C is mounted on the substrate P.

Incidentally, in the present embodiment, a cable holding member 15 and a cable holding member 16 for holding cables such as power cables are provided respectively on the X-axis driving unit 12 and the Y-axis driving unit 13. Each of the cable holding member 15 and the cable holding member 16 includes, for example, a cableveyor so that it can be bent.

The mounting head 8 includes a nozzle driving portion cable of moving the nozzle 7 in the Z-axis direction and the θZ direction. The nozzle driving portion includes an actuator for generating power capable of moving the nozzle 7. Specifically, in the present embodiment, the nozzle 7 can be moved by the mounting head moving device 9 and the nozzle driving portion provided on the mounting head 8 in the four directions of the X-axis, Y-axis, Z-axis and θZ directions. It is noted that the nozzle 7 may be movable in the six directions of the X-axis, Y-axis, Z-axis, θX, θY and θZ directions.

The mounting head 8 includes an imaging portion 17 capable of obtaining image information of the electronic component C and image information of the substrate P. When the mounting head 8 moves, the imaging portion 17 moves together with the nozzle 7. The imaging portion 17 is an imaging portion to be used for teaching.

The imaging portion 17 obtains the image information of the electronic component C and the image information of the substrate P in the supplying position where the electronic component C is supplied from the supplying device 2. The image information of the substrate P includes image information of a mark provided on the substrate P. On the basis of the image information obtained by the imaging portion 17, the holding position (the sucking position) of the nozzle 7 for the electronic component C in the X-axis direction and the Y-axis direction and the mounting position of the electronic component C on the substrate P are adjusted.

Besides, the mounting head 8 includes a height sensor (not shown) irradiating the electronic component C and the substrate P with detection light and receiving the detection light having been reflected on the electronic component C and the substrate P. The height sensor detects the position of the electronic component C and the position of the substrate P in the Z-axis direction. On the basis of the detection result obtained by the height sensor, the holding position of the electronic component C and the mounting position of the electronic component C on the substrate P in the Z-axis direction are adjusted.

It is noted that the mounting head 8 may have a detecting section for detecting a bad mark or the like provided on a split substrate or the like.

The mounting apparatus 1 further includes an imaging portion 18 disposed on the base member 5 and capable of obtaining image information of the electronic component C. The imaging portion 18 obtains the image information of the electronic component C held by the nozzle 7 from below. Specifically, the imaging portion 18 obtains the image information of a lower surface side of the electronic component C. On the basis of the image information obtained by the imaging portion 18, a positional shift between a sucking center and the center of the electronic component and the inclination of the electronic component C are obtained.

The controller 10 controls the mounting apparatus 1. The controller 10 includes a processor and a memory. The processor includes a CPU (Central Processing Unit). The memory includes a ROM (Read Only Memory) and a RAM (Random Access Memory). The controller 10 is connected to the server 3 via the cable 4. The controller 10 receives a control signal from the server 3 via the cable 4 for controlling the mounting apparatus 1. The controller 10 outputs various information of the mounting apparatus 1 to the server 3 via the cable 4.

The supplying device 2 supplies the electronic component C to the mounting head 8 (the nozzle 7). The supplying device 2 includes a feeder 21 supporting a reel 20, and a feeder bank 22 supporting the feeder 21. A tape holding electronic components C is wound around the reel 20. The reel 20 supports the tape holding the electronic components C. The reel 20 supporting the tape is supported by the feeder 21. The reel 20 supports the electronic components C via the tape. The feeder 21 supports the electronic components C via the reel 20 and the tape. The feeder bank 22 supports the electronic components C via the feeder 21, the reel 20 and the tape.

The feeder 21 is provided in a plural number to be arranged in a moving direction of the substrate P moved by the substrate moving device 6. In the present embodiment, a plurality of feeders 21 are arranged in the X-axis direction. Each feeder 21 supplies the electronic component C to the mounting apparatus 1. The feeder bank 22 functions as a supporting member for supporting the feeders 21. The plural feeders 21 are arranged in the feeder bank 22 in the X-axis direction. The feeder bank 22 removably supports the plural feeders 21.

On each of the plural feeders 21, the reel 20 is supported. Each feeder 21 removably supports the reel 20. On the tape wound around the reel 20, a plurality of electronic components C are held. As the reel 20 is rotated, the electronic components C held on the tape are successively moved to the supplying position. In the supplying position, each electronic component C is held by the nozzle 7.

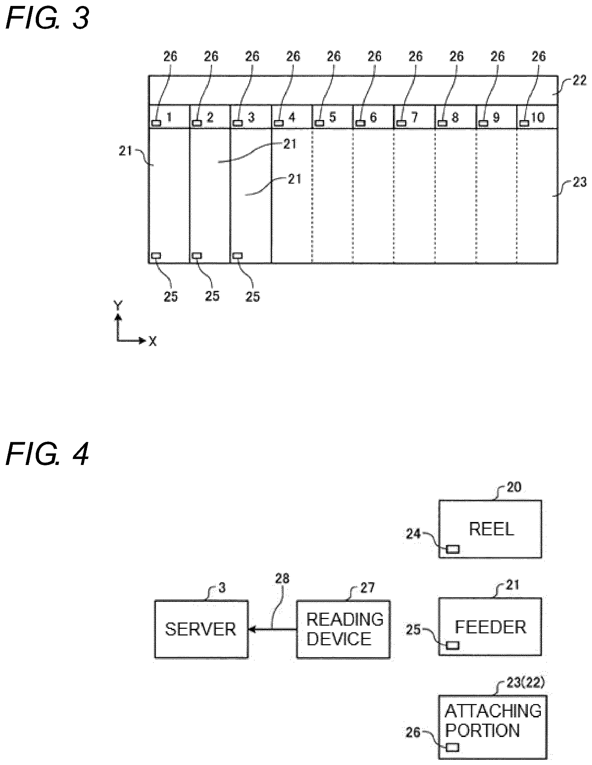

FIG. 3 is a schematic diagram illustrating an example of the feeders 21 and the feeder bank 22 of the present embodiment. The feeder bank 22 includes a plurality of attaching portions 23 to which the feeders 21 are respectively attached. The feeders 21 are attached respectively to these attaching portions 23. In the example illustrated in FIG. 3, the feeder bank 22 has ten attaching portions 23, which are respectively numbered as the "first" to "tenth" attaching portions. It is noted that the number of the attaching portions 23 is not limited to ten. The attaching portions 23 may be provided, for example, in number of 100.

In the following description, for convenience sake, a reel 20 around which a tape holding an electronic component C is wound is suitably designated as the reel 20 of the electronic component C, a feeder 21 supporting this reel 20 is suitably designated as the feeder 21 of the electronic component C, and an attaching portion 23 of the feeder bank 22 to which this feeder 21 is attached is suitably designated as the attaching portion 23 of the electronic component C.

Besides, in the following description, an electronic component C held on a tape wound around a reel 20 is suitably designated as the electronic component C of the reel 20, an electronic component C held on a tape wound around a reel 20 supported by a feeder 21 is suitably designated as the electronic component C of the feeder 21, and an electronic component C held on a tape of a reel 20 supported by a feeder 21 attached to a attaching portion 23 is suitably designated as the electronic component C of the attaching portion 23.

In general, a reel 20 of electronic components C is supplied from a supplier of electronic components to a manufacturer for manufacturing products by using the electronic component mounting system 100. In the following description, a reel 20 supplied from the supplier but not used for the mounting yet is suitably designated to be in a brand-new state or in an initial state. A reel 20 in a brand-new state supports a large number of electronic components C.

When a reel 20 in a brand-new state is used in the mounting, the number of electronic components C supported on the reel 20 is reduced. In the following description, a reel 20 in which some electronic components C have already been used for the mounting is suitably designated to be in a used state. Besides, in the following description, a reel 20 in which all electronic components C have already been used for the mounting is suitably designated to be in a component shortage state. A reel 20 in a component shortage state supports no electronic component C. The number of electronic components C remaining in the reel 20 in a component shortage state is zero.

FIG. 4 is a schematic diagram illustrating an example of the reel 20, the feeder 21 and the attaching portion 23 of the present embodiment.

As illustrated in FIG. 4, each of the plural reels 20 (or tapes) is provided with an identifier 24. The identifier 24 includes information peculiar to the corresponding reel 20. The identifier 24 is used for identifying each of the plural reels 20.

As illustrated in FIGS. 3 and 4, each of the plural feeders 21 is provided with an identifier 25. The identifier 25 includes information peculiar to the corresponding feeder 21. The identifier 25 is used for identifying each of the plural feeders 21.

As illustrated in FIGS. 3 and 4, each of the plural attaching portions 23 of the feeder bank 22 is provided with an identifier 26. The identifier 26 includes information peculiar to the corresponding attaching portion 23. The identifier 26 is used for identifying each of the plural attaching portions 23.

In the present embodiment, each of the identifier 24, the identifier 25 and the identifier 26 includes a bar code. The bar code may be a one-dimensional bar code or a two-dimensional bar code.

As illustrated in FIG. 4, the electronic component mounting system 100 includes a reading device 27 for detecting the identifier 24, the identifier 25 and the identifier 26. The reading device 27 includes a bar code reader or a handy terminal, and can read the identifier 24, the identifier 25 and the identifier 26. The reading device 27 is connected to the server 3 via a cable 28. A detection result (read result) of the reading device 27 is output to the server 3 via the cable 28.

The server 3 can specify, on the basis of a detection result of the reading device 27 for an identifier 24, the type of electronic component C of the reel 20 having the identifier 24 out of the plural reels 20. In other words, the server 3 can specify which type of electronic component C is supported by the reel 20.

The server 3 can specify, on the basis of a detection result of the reading device 27 for an identifier 25, a feeder 21 having the identifier 25 among the plural feeders 21. In other words, the server 3 can specify which of the feeders 21 the feeder having the identifier 25 is. Besides, on the basis of the detection result of the reading device 27 for the identifier 24 and the detection result of the reading device 27 for the identifier 25, the server 3 can specify the type of electronic component C of the feeder 21.

The server 3 can specify, on the basis of a detection result of the reading device 27 for an identifier 26, an attaching portion 23 having the identifier 26 among the plural attaching portions 23. In other words, the server 3 can specify which of the attaching portions 23 the attaching portion 23 having the identifier 26 is. Besides, on the basis of the detection result of the reading device 27 for the identifier 24, the detection result of the reading device 27 for the identifier 25, and the detection result of the reading device 27 for the identifier 26, the server 3 can specify the type of electronic component C of the attaching portion 23.

The server 3 can associate, on the basis of the detection results of the reading device 27 for the identifier 24, the identifier 25 and the identifier 26, the reel 20, the feeder 21 and the attaching portion 23 to one another. In other words, on the basis of the detection results of the reading device 27, the server 3 can specify which reel 20 is supported by which feeder 21 and which attaching portion 23 the feeder 21 is attached to. In this manner, on the basis of the detection results of the reading device 27, the server 3 can perform unified management of the arrangement of feeders 21 in the feeder bank 22 and the correspondence of reels 20 to the feeders 21.

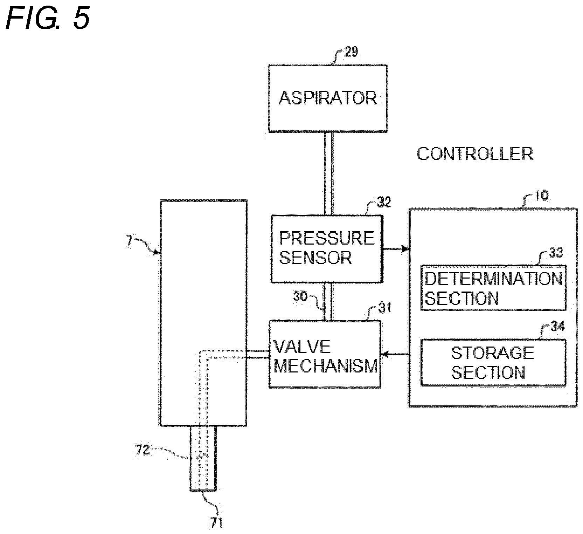

FIG. 5 is a diagram illustrating an example of the nozzle 7 of the present embodiment. As illustrated in FIG. 5, the nozzle 7 includes an opening 71 formed at the tip thereof and an internal channel 72 connected to the opening 71. The internal channel 72 is connected through a channel of a pipe 30 to an aspirator 29 including a vacuum pump. The aspirator 29 can suck a gas present in the internal channel 72 of the nozzle 7.

In the pipe 30, a valve mechanism 31 is provided. The valve mechanism 31 can open/close the channel of the pipe 30. The valve mechanism 31 is controlled by the controller 10. When the aspirator 29 is operated with the channel of the pipe 30 opened by the valve mechanism 31, the gas present in the internal channel 72 is sucked by the aspirator 29 to execute a sucking operation of the nozzle 7. When the channel of the pipe 30 is closed by the valve mechanism 31, the sucking operation of the nozzle 7 is canceled (stopped). When the sucking operation of the nozzle 7 is executed with the tip of the nozzle 7 in contact with an electronic component C, the electronic component C is sucked to be held on the tip of the nozzle 7. When the sucking operation of the nozzle 7 is cancelled, the electronic component C is released from the nozzle 7.

The mounting apparatus 1 includes a holding state sensor 32 for detecting a holding state of the nozzle 7 for an electronic component C. The holding state sensor 32 detects whether or not an electronic component C is held by the nozzle 7. The holding state sensor 32 is provided in the pipe 30. In the present embodiment, the holding state sensor 32 includes a pressure sensor for detecting a pressure in the channel of the pipe 30. In the following description, the holding state sensor 32 is suitably designated as a pressure sensor 32.

The pressure sensor 32 detects, for example, a degree of vacuum of the channel of the pipe 30 (i.e., a difference between an absolute pressure in the channel of the pipe 30 and the atmospheric pressure). As the degree of vacuum is higher, the absolute pressure is lower. A detection result obtained by the pressure sensor 32 is output to the controller 10.

The controller 10 includes a determination section 33 for determining, on the basis of a detection result of the pressure sensor 32, whether or not an electronic component C has been held by the nozzle 7, and a storage section 34 for storing pressure data (vacuum degree data) of the channel of the pipe 30 obtained when the nozzle 7 holds (sucks) the electronic component C. The vacuum degree data can be precedently obtained by, for example, a preliminary experiment or simulation, and is stored in the storage section 34.

The determination section 33 can determine, by comparing a detection result of the pressure sensor 32 with the vacuum degree data stored in the storage section 34, whether or not an electronic component C has been held by the nozzle 7. In the state where the electronic component C is held by the nozzle 7, the opening 71 is closed by the electronic component C. Therefore, the pressure in the channel of the pipe 30 is low (i.e., the degree of vacuum is high). In the state where the electronic component C is not held by the nozzle 7, the opening 71 is open. Therefore, the pressure in the channel of the pipe 30 is high (i.e., the degree of vacuum is low). Accordingly, the determination section 33 can determine, on the basis of the detection result of the pressure sensor 32 and the vacuum degree data stored in the storage section 34, whether or not an electronic component C has been held by the nozzle 7.

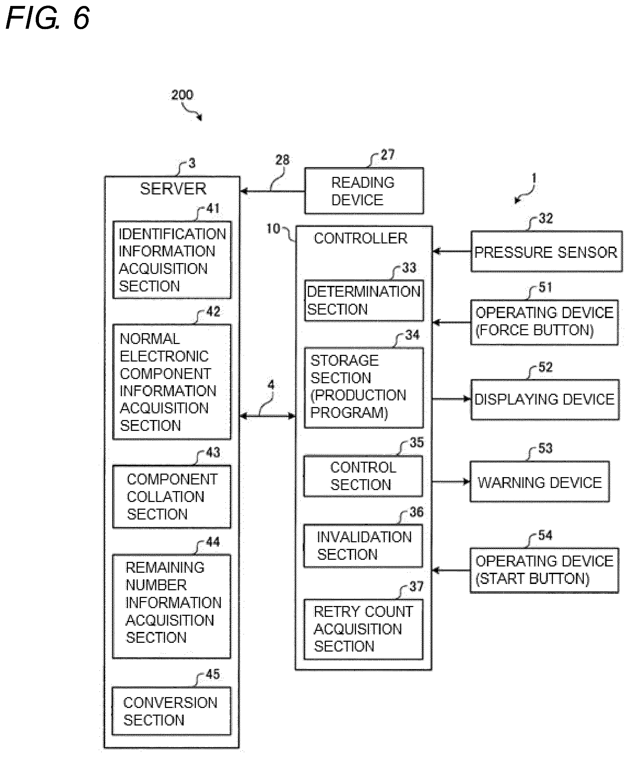

FIG. 6 is a functional block diagram of a control system 200 including the server 3 and the controller 10 of the present embodiment. Incidentally, at least a part of functions of the server 3 described below may be included in the functions of the controller 10, or at least a part of the functions of the controller 10 may be included in the functions of the server 3.

In FIG. 6, an example in which the server 3 is connected to one controller 10 is illustrated for convenience sake. As described above, in the present embodiment, the electronic component mounting system 100 includes a plurality of mounting apparatuses 1 (controllers 10). The server 3 is connected to the plural controllers 10.

As illustrated in FIG. 6, the mounting apparatus 1 includes the controller 10, an operating device 51, a displaying device 52, a warning device 53, and an operating device 54. Each of the operating device 51, the displaying device 52, the warning device 53 and the operating device 54 is connected to the controller 10.

The operating device 51 includes, for example, an operation button to be operated by an operator. In the present embodiment, when the operating device 51 is operated, the operating device 51 generates an operation signal. The operation signal generated by the operating device 51 is output to the controller 10.

The displaying device 52 includes, for example, a flat panel display, and displays various information including characters and images. The displaying device 52 displays information on the basis of a control signal output from the controller 10. An operator can grasp the situation of the mounting apparatus 1 based on information displayed in the displaying device 52.

In the present embodiment, the operating device 51 includes an operation screen (an image button) displayed in the displaying device 52. For example, a pointer is operated in the operation screen by an input device such as a mouse or a keyboard. When the operation screen is operated by using the pointer, an operation signal is generated. Incidentally, the operating device 51 may include a touch panel so as to generate an operation signal by operating the touch panel. The operating device 51 may include a mechanical button such as a rocker switch.

The operating device 54 includes, for example, an operation button to be operated by an operator. In the present embodiment, when the operating device 54 is operated, the operating device 54 generates an operation signal. The operation signal generated by the operating device 54 is output to the controller 10. The operating device 54 may be an image button or a mechanical button similarly to the operating device 51.

The warning device 53 includes, for example, a warning lamp to inform about warning information with light. The warning device 53 may include a siren for informing about the warning information by generating sound. The warning device 53 generates a warning on the basis of a control signal output from the controller 10. An operator can grasp the situation of the mounting apparatus 1 based on the warning information generated by the warning device 53.

The controller 10 includes the determination section 33, the storage section 34, a control section 35, an invalidation section 36 and a retry count acquisition section 37.

The server 3 includes an identification information acquisition section 41, a normal electronic component information acquisition section 42, a component collation section 43, a remaining number information acquisition section 44, and a conversion section 45.

The determination section 33 determines, on the basis of a detection result of the pressure sensor 32, whether or not an electronic component C has been held by the nozzle 7. The storage section 34 stores the vacuum degree data.

The storage section 34 stores information on mounting conditions (recipe) of the mounting apparatus 1. The mounting conditions include a sequence for producing a product by the mounting apparatus 1 and an instruction, setting and parameters to be issued to the mounting apparatus 1. The information on the mounting conditions is output from the server 3 to the controller 10 of each of the plural mounting apparatuses 1. The storage section 34 stores the information on the mounting conditions supplied from the server 3. In the following description, the information on the mounting conditions is suitably designated as a production program.

The production program includes substrate information of a substrate P on which an electronic component is to be mounted, and normal electronic component information of an electronic component C to be mounted on the substrate P.

The control section 35 outputs a control signal for controlling the mounting apparatus 1. The control signal includes a start instructing signal for instructing to start a mounting operation of the mounting apparatus 1, an operation instructing signal corresponding to a content of the mounting operation of the mounting apparatus 1, and a halt instructing signal for instructing to halt the mounting operation of the mounting apparatus 1. The control section 35 can output a control signal (a start instructing signal or an operation instructing signal) to the substrate moving device 6, the mounting head moving device 9, the aspirator 29, the valve mechanism 31 and the like, so that the mounting operation can be performed. The control section 35 can output a control signal (a halt instructing signal) to the substrate moving device 6, the mounting head moving device 9, the aspirator 29, the valve mechanism 31 and the like, so that the mounting operation can be halted.

The invalidation section 36 invalidates the operating device 51. The invalidation of the operating device 51 includes that the operation signal generated by the operating device 51 is invalidated (for example, by erasing). The invalidation of the operating device 51 includes that the operation signal generated by the operating device 51 is not output to the sever 3. If the operating device 51 includes an operation button (an image button) to be displayed in the displaying device 52, the invalidation of the operating device 51 includes that the image button is not displayed in the displaying device 52.

The retry count acquisition section 37 acquires retry count information corresponding to the number of retries of the holding action of the nozzle 7 made when it is determined by the determination section 33 that an electronic component C has not been held by the nozzle 7. If it is determined by the determination section 33 that an electronic component C has not been held by the nozzle 7 although the holding action of the nozzle 7 for the electronic component C has been executed based on the production program, the holding action of the nozzle 7 is retried. The retry count acquisition section 37 acquires the retry count information corresponding to the number of retries (the retry count) of the holding action of the nozzle 7 executed when the electronic component C has not been held by the nozzle 7. The number of retries is equal to the number of holding failures in which the nozzle 7 has failed to hold (suck) the electronic component C.

As described above, the holding state of the nozzle 7 for an electronic component C is detected by the pressure sensor 32. The determination section 33 determines on the basis of the detection result of the pressure sensor 32 whether or not the electronic component C has been held by the nozzle 7. The determination result of the determination section 33 is output to the control section 35. If it is determined by the determination section 33 that the electronic component C has not been held by the nozzle 7, the control section 35 causes the holding action of the nozzle 7 for the electronic component C to be retried. Also in the retry of the holding action of the nozzle 7, the holding state of the nozzle 7 for the electronic component C is detected by the pressure sensor 32. On the basis of the detection result of the pressure sensor 32, the determination section 33 determines whether or not the electronic component C has been held by the nozzle 7. The retry count acquisition section 37 acquires the retry count information corresponding to the number of such reties.

In the present embodiment, the retry count information acquired by the retry count acquisition section 37 is output to the displaying device 52. The displaying device 52 displays the retry count information output from the retry count acquisition section 37.

In the present embodiment, the control section 35 causes the holding action of the nozzle 7 to be retried until the number of retries of the holding action of the nozzle 7 exceeds a precedently determined threshold value. Incidentally, the control section 35 may repeat the retry of the holding action of the nozzle 7 until the determination section 33 determines that the electronic component C has been held by the nozzle 7. If the determination section 33 determines that the electronic component C has been held by the nozzle 7 before the number of retires reaches the threshold value, the retry of the holding action of the nozzle 7 is terminated.

The identification information acquisition section 41 acquires identification information for identifying an electronic component C of the supplying device 2. The identification information of an electronic component C includes the identification information of a reel 20 supporting the electronic component C, the identification information of a feeder 21 supporting the reel 20, and the identification information of an attaching portion 23 of the feeder bank 22 supporting the feeder 21. The identification information of the reel 20 includes a detection result of the reading device 27 for an identifier 24 provided on the reel 20. The identification information of the feeder 21 includes a detection result of the reading device 27 for an identifier 25 provided on the feeder 21. The identification information of the attaching portion 23 of the feeder bank 22 includes a detection result of the reading device 27 for an identifier 26 provided on the attaching portion 23. The identification information of the reel 20, the identification information of the feeder 21 and the identification information of the attaching portion 23 are output from the reading device 27 through the cable 28 to the server 3. The identification information acquisition section 41 of the server 3 acquires the identification information of the electronic component C including the identification information of the reel 20, the identification information of the feeder 21 and the identification information of the attaching portion 23 output from the reading device 27.

The normal electronic component information acquisition section 42 acquires normal electronic component information corresponding to an electronic component C to be mounted on a substrate P. In the present embodiment, the production program stored in the storage section 34 includes substrate information corresponding to a substrate P on which an electronic component is to be mounted, and normal electronic component information corresponding to an electronic component C to be mounted on the substrate P. The stored information of the storage section 34 is output through the cable 4 to the server 3. The normal electronic component information acquisition section 42 of the server 3 acquires the substrate information corresponding to the substrate P on which the electronic component is to be mounted and the normal electronic component information corresponding to the electronic component C to be mounted on the substrate P output from the storage section 34.

In the following description, an electronic component C to be mounted on a substrate P defined by the production program is suitably designated as a normal electronic component C, and an electronic component C that is not a normal electronic component C defined by the production program is suitably designated as a non-normal electronic component C. A non-normal electronic component C is an electronic component C not to be mounted on a substrate P.

The component collation section 43 collates the identification information of an electronic component C acquired by the identification information acquisition section 41 with the normal electronic component information acquired by the normal electronic component information acquisition section 42. Besides, the component collation section 43 determines, based on the collation result, whether or not the electronic component C of the supplying device 2 is a normal electronic component C. If it is determined that the electronic component C of the supplying device 2 is a normal electronic component C, the component collation section 43 outputs a "positive determination (OK determination)". If it is determined that the electronic component C of the supplying device 2 is a non-normal electronic component C, the component collation section 43 outputs a "negative determination (NG determination)".

The production program specifies the position of a normal electronic component C in the supplying device 2. For example, in a sequence for mounting a given electronic component C on a given substrate P, the production program specifies the position of a feeder 21 of the electronic component C as the "5th" attaching portion 23. The component collation section 43 collates the identification information of the electronic component C obtained by the reading device 27 with the normal electronic component information acquired from the production program, so as to determine whether or not the electronic component C of the "5th" attaching portion 23 is a normal electronic component C. If it is determined that the electronic component C of the "5th" attaching portion 23 is a normal electronic component C, the component collation section 43 outputs an "OK determination", and if it is determined that the electronic component C of the "5th" attaching portion 23 is a non-normal electronic component C, the component collation section 43 outputs an "NG determination".

In the present embodiment, the determination result of the component collation section 43 is output to the displaying device 52. The displaying device 52 displays the determination result output from the component collation section 43.

The remaining number information acquisition section 44 acquires remaining number information corresponding to the remaining number of electronic components C in the supplying device 2. The remaining number of electronic components C in the supplying device 2 includes the remaining number of electronic components C in each reel 20 (each feeder 21). Through the mounting of electronic components C on a substrate P, the remaining number of electronic components C in the reel 20 is reduced. The remaining number information acquisition section 44 acquires the remaining number information corresponding to the remaining number of electronic components C in each of the plural reels 20.

The control section 35 has a counting function of counting the number of mounting actions of the nozzle 7. The number of mounting actions corresponds to the number of times of the nozzle 7 executing the operation for mounting an electronic component C disposed in the supplying position onto a substrate P. The number of mounting actions is equal to the number of holding successes in which the nozzle 7 can successfully hold (suck) an electronic component C.

The information on the number of mounting actions is output from the control section 35 to the server 3. In a reel 20 in a brand-new state, the number of electronic components C held on the reel 20 is known information. The remaining number information acquisition section 44 acquires the remaining number information corresponding to the remaining number of electronic components C in the supplying device 2 on the basis of the known information of the number of electronic components C held on a reel 20 in a brand-new state and the number of mounting actions output from the control section 35.

In the present embodiment, the remaining number information acquired by the remaining number information acquisition section 44 is output to the displaying device 52. The displaying device 52 displays the remaining number information output from the remaining number information acquisition section 44.

Besides, in the present embodiment, if it is determined, on the basis of the remaining number information acquired by the remaining number information acquisition section 44, that the remaining number of electronic components C in the supplying device 2 is smaller than a precedently determined threshold value, the control section 35 causes the warning device 53 to function.

The conversion section 45 converts a determination result of the component collation section 43. For example, if the component collation section 43 outputs an "OK determination", the conversion section 45 converts the determination result into an "NG determination". Alternatively, if the component collation section 43 outputs an "NG determination", the conversion section 45 converts the determination result into an "OK determination".

The control section 35 controls the mounting apparatus 1 on the basis of the determination result of the component collation section 43. If the determination result of the component collation section 43 is an "NG determination", the control section 35 halts the mounting operation of the mounting apparatus 1. The "NG determination" of the component collation section 43 means that the electronic component C of the feeder 21 of the supplying device 2 is a non-normal electronic component C. After the mounting operation for electronic components C of a given reel 20 is completed, the reel in a component shortage state is exchanged with a reel 20 in a brand-new state for replenishing the electronic components C, and if the determination result of the component collation section 43 for electronic components C of the reel 20 in a brand-new state is an "NG determination", the control section 35 outputs a halt instructing signal for instructing to halt the mounting operation so as to halt the mounting operation of the mounting apparatus 1. In this manner, the mounting of a non-normal electronic component C on the substrate P can be inhibited.

The operating device 51 can generate an operation signal for converting an "NG determination" of the component collation section 43 into an "OK determination". When the operating device 51 is operated, an operation signal generated by operating the operating device 51 is output to the conversion section 45 of the server 3. If the component collation section 43 outputs an "NG determination", the conversion section 45 converts, on the basis of the operation signal output from the operating device 51, the "NG determination" of the component collation section 43 into an "OK determination".

The "NG determination" of the component collation section 43 is forcedly converted into an "OK determination" by operating the operating device 51. In the present embodiment, the operating device 51 includes an operation button designated as a force button.

As described above, if the determination result of the component collation section 43 is an "NG determination", the control section 35 halts the mounting operation of the mounting apparatus 1. In other words, if the component collation section 43 outputs an "NG determination", the control section 35 does not perform the mounting operation. When the operating device 51 is operated to convert the "NG determination" of the component collation section 43 into an "OK determination", the control section 35 performs the mounting operation.

The operating device 54 can generate an operation signal for causing the control section 35 to output a start instructing signal. When the operating device 54 is operated, an operation signal generated by operating the operating device 54 is output to the control section 35. The control section 35 outputs, on the basis of the operation signal output from the operating device 54, a start instructing signal for instructing to start the mounting operation of the mounting apparatus 1.

In the present embodiment, the operating device 54 includes an operation button designated as a start button for starting the mounting operation of the mounting apparatus 1.

The invalidation section 36 invalidates the operating device 51 on the basis of the remaining number information acquired by the remaining number information acquisition section 44. For example, even if the operation signal for converting the "NG determination" of the component collation section 43 into an "OK determination" is generated by the operating device 51, the invalidation section 36 places the operation signal in an erased or non-output state on the basis of the remaining number information corresponding the remaining number of electronic components C in the supplying device 2. Besides, if the operating device 51 includes the operation screen (the image button) to be displayed in the displaying device 52, the invalidation section 36 places the image button in a non-displayed state on the basis of the remaining number information corresponding to the remaining number of electronic components C in the supplying device 2.

The control system 200 has a false-mounting preventing function and a component remaining number managing function. The false-mounting preventing function includes a component collating function. The component remaining number managing function includes a component shortage warning function.

The false-mounting preventing function is a function to prevent a non-normal electronic component C from being attached to the attaching portion 23 by confirming whether or not a normal electronic component C has been attached to a normal attaching portion 23 (including a feeder 21 and a reel 20) on the basis of the production program. The component collating function is a function to collate an electronic component C of the supplying apparats 2 with the normal electronic component information (the production program) to determine whether or not the electronic component C of the supplying device 2 is a normal electronic component C. As described above, the control system 200 includes the component collation section 43 that collates the identification information with the normal electronic component information to determine whether or not an electronic component C of the supplying device 2 is a normal electronic component C. The control system 200 exhibits the false-mounting preventing function including the component collating function by using the component collation section 43 and the like.

The component remaining number managing function is a function to manage the remaining number of electronic components C in the supplying device 2 (the reel 20). The component shortage warning function is a function to warn that the remaining number of electronic components C in the reel 20 is smaller than the precedently determined threshold value. As described above, the control system 200 includes the remaining number information acquisition section 44 that acquires the remaining number information corresponding to the remaining number of electronic components C in the supplying device 2. Besides, if the remaining number of electronic components C in the supplying device 2 is smaller than the precedently determined threshold value, the control section 35 causes the warning device 53 to function. The control system 200 exhibits the component remaining number managing function including the component shortage warning function by using the remaining number information acquisition section 44, the warning device 53 and the like.

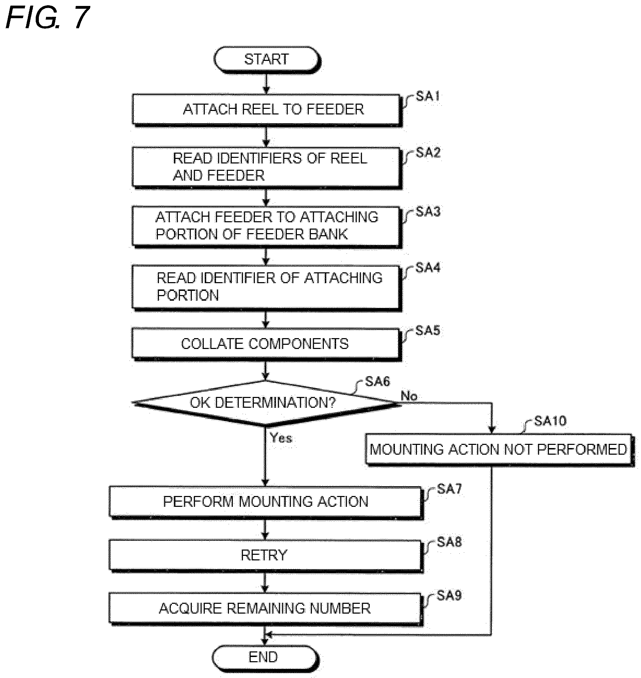

Next, an example of an operation of the present embodiment will be described with reference to FIG. 7. FIG. 7 is a flowchart illustrating an example of an electronic component mounting method of the present embodiment.

In the present embodiment, an operation of attaching a feeder 21 to an attaching portion 23 of the feeder bank 22 and an operation of attaching a reel 20 to an feeder 21 are carried out by an operator.

Besides, in the present embodiment, an operation of reading the identifier 24, the identifier 25 and the identifier 26 by using the reading device 27 is carried out by an operator. In the following description, an operation of reading (detecting) at least one of the identifier 24, the identifier 25 and the identifier 26 by using the reading device 27 is suitably designated as a reading operation.

The operation of attaching a reel 20 in a brand-new state to a feeder 21 is carried out by an operator (step SA1). The reel 20 in a brand-new state holds, for example, 1000 electronic components C. Such a reel 20 in a brand-new state is attached to the feeder 21.

After step SA1, the operation of reading the identifier 24 of the reel 20 and the operation of reading the identifier 25 of the feeder 21 by using the reading device 27 are carried out by the operator (step SA2). The detection result of the reading device 27 is output to the identification information acquisition section 41 of the server 3. The identification information acquisition section 41 can associate the reel 20 with the feeder 21 on the basis of the detection result of the reading device 27 obtained in step SA2. In other words, the identification information acquisition section 41 can grasp which reel 20 has been attached to which feeder 21.

The operation of attaching the feeder 21 to an attaching portion 23 of the feeder bank 22 is carried out by the operator (step SA3).

After step SA3, the operation of reading the identifier 26 of the attaching portion 23 by using the reading device 27 is carried out by the operator (step SA4). The detection result of the reading device 27 is output to the identification information acquisition section 41 of the server 3. The identification information acquisition section 41 can associate the feeder 21 with the attaching portion 23 on the basis of the detection result of the reading device 27 obtained in step SA2 and the detection result of the reading device 27 obtained in step SA4. In other words, the identification information acquisition section 41 can grasp which feeder 21 has been attached to which attaching portion 23.

The component collation section 43 collates the identification information of an electronic component C present in the supplying device 2, which includes the identification information of the attaching portion 23, the identification information of the feeder 21 and the identification information of the reel 20 obtained in steps SA2 and SA4, with the normal electronic component information that is defined in the production program and corresponds to an electronic component C to be mounted on a substrate P (step SA5).

The component collation section 43 determines, on the basis of the collation result obtained in step SA5, whether or not the electronic component C of the supplying device 2 is a normal electronic component C (step SA6).

If it is determined that the electronic component C of the supplying device 2 is a normal electronic component C, the component collation section 43 outputs an "OK determination". If it is determined that the electronic component C of the supplying device 2 is a non-normal electronic component C, the component collation section 43 outputs an "NG determination".

The control section 35 controls the mounting apparatus 1 on the basis of the determination result of the component collation section 43.

If the "NG determination" is output (namely, NO) in step SA6, the control section 35 does not perform the mounting operation of the mounting apparatus 1 (step SA10). If the mounting operation has been performed, the control section 35 outputs a halt instructing signal for instructing to halt the mounting operation of the mounting apparatus 1.

The "NG determination" of the component collation section 43 means that the electronic component C of the feeder 21 is a non-normal electronic component C. If the determination result of the component collation section 43 is the "NG determination", the control section 35 halts the mounting operation of the mounting apparatus 1 by outputting a halt instructing signal for instructing to halt the mounting operation. Thus, a non-normal electronic component C can be inhibited from being mounted on the substrate P.

If the "OK determination" is output (namely, YES) in step SA6, the control section 35 performs the mounting operation of the mounting apparatus 1 (step SA7). The operating device 54 is operated by the operator. An operation signal generated by operating the operating device 54 is output to the control section 35. The control section 35 outputs a start instructing signal for instructing to start the mounting operation of the mounting apparatus 1. Thus, the mounting operation is started.

When the start instructing signal for instructing to start the mounting operation is output, the electronic component C is supplied from the feeder 21 of the supplying device 2 to the supplying position based on the production program. In other words, the electronic component C is supplied to the supplying position from the feeder 21 specified by the production program out of the plural feeders 21 of the supplying device 2. The control section 35 controls the mounting head moving device 9 to move the nozzle 7 to the supplying position. The control section 35 brings the tip of the nozzle 7 into contact with the electronic component C in the supplying position. The control section 35 controls the aspirator 29 and the valve mechanism 31, with the tip of the nozzle 7 and the electronic component C in contact with each other, to execute the sucking operation of the nozzle 7. Thus, the electronic component C is held by the nozzle 7. The control section 35 controls the mounting head moving device 9 and the nozzle driving portion to move the nozzle 7 holding the electronic component C to the mounting position. The control section 35 loads the electronic component C held by the nozzle 7 onto the substrate P in the mounting position. After loading the electronic component C onto the substrate P, the control section 35 controls the aspirator 29 and the valve mechanism 31 to cancel the sucking operation of the nozzle 7. Thus, the electronic component C is mounted on the substrate P.

The control section 35 performs the above-described mounting action by a plurality of times to mount a plurality of electronic components C on the substrate P.

During a plurality of mounting actions, there is a possibility of occurrence of a situation where an electronic component C is not held by the nozzle 7. If the electronic component C is not held by the nozzle 7, the control section 35 executes the retry of the holding action of the nozzle 7 (step SA8).

The determination section 33 determines, on the basis of the detection result of the pressure sensor 32, whether or not an electronic component C has been held by the nozzle 7. The retry count acquisition section 37 acquires the retry count information corresponding to the number of retries of the holding action of the nozzle 7.

Through the mounting, the number of electronic components C in the supplying device 2 is reduced. The remaining number information acquisition section 44 acquires the remaining number information corresponding to the remaining number of electronic components C in the supplying device 2 (step SA9).

The remaining number information acquisition section 44 determines whether or not the remaining number of electronic components C in the feeder 21 of the supplying device 2 is zero, or equal to or smaller than a precedently determined threshold value. The threshold value can be arbitrarily set. In the present embodiment, it is assumed that the threshold value is 50.

If it is determined that the remaining number of electronic components C is zero, or equal to or smaller than the threshold value, the warning device 53 functions owing to the component shortage warning function of the control system 200. Besides, the information that the remaining number of electronic components C in the feeder 21 is zero, or equal to or smaller than the threshold value is displayed in the displaying device 52.

On the basis of the warning information of the warning device 53, the operator exchanges the reel 20 in a component shortage state or the reel 20 in a used state having a small remaining number with a reel 20 in a brand-new state. In other words, the operation of step SA1 is performed. Hereinafter, the processing of step SA1 to step SA9 is repeatedly performed.

The mounting operation is completed when the mounting of a prescribed number of substrates P has been completed.

As described above, in the present embodiment, if it is determined, on the basis of the result of the collation between the identification information and the normal electronic component information, that the electronic component C of the reel 20 (the feeder 21) is a non-normal electronic component C, the component collation section 43 outputs an "NG determination".

Besides, in the present embodiment, if it is determined that the reel 20 (the feeder 21) is in a component shortage state, the component collation section 43 outputs an "NG determination". If it is determined, for example, in step SA9, on the basis of the remaining number information acquired by the remaining number information acquisition section 44 that the remaining number of electronic components C in the reel 20 (the feeder 21) has become zero, the component collation section 43 outputs an "NG determination".

The occurrence of a reel 20 in a component shortage state means that there is no electronic component C (a collation target) to be collated with the normal electronic component information (the production program). Besides, if there occurs a reel 20 in a component shortage state, there is a high necessity of exchanging the reel 20 in a component shortage state with a reel 20 in a brand-new state. When a reel 20 in a brand-new state is attached to a feeder 21, it is necessary for the control system 200 to exhibit the false-mounting preventing function. In the present embodiment, if there occurs a reel 20 in a component shortage state (if there occurs a situation where there is a high necessity of exchanging a reel 20), the false-mounting preventing function is exhibited by the component collation section 43 outputting an "NG determination".

As described above, if an "NG determination" is output, the control section 35 does not perform the mounting operation. Accordingly, in order to perform (resume) the mounting operation, it is necessary to convert the "NG determination" into an "OK determination". In order to obtain the "OK determination", it is necessary to perform the reading operation by an operator to acquire the identification information of an electronic component C by the reading operation, and to collate the identification information with the normal electronic component information defined by the production program to determine whether or not the electronic component C is a normal electronic component C.

In the following description, a series of processing including the reading operation, the acquisition of the identification information of an electronic component C, the collation of the identification information of the electronic component C with the normal electronic component information, and the determination whether or not the electronic component C is a normal electronic component C is suitably designated as component collation processing.

Specifically, in the present embodiment, if there occurs a reel 20 in a component shortage state, the control system 200 creates, for resuming the mounting operation, a situation where the component collation processing including the reading operation performed by an operator should be unavoidably carried out. In this manner, in the present embodiment, if there occurs a reel 20 in a component shortage state (if there occurs a situation where there is a high necessity of exchanging a reel 20), the component collation section 43 outputs an "NG determination", so that the component collation processing including the reading operation performed by an operator is definitely carried out. Therefore, the control system 200 can exhibit the false-mounting preventing function.

Specifically, in the present embodiment, if it is determined that a reel 20 (a feeder 21) is in a component shortage state, the control system 200 causes the component collation section 43 to output an "NG determination" to urge an operator to perform the reading operation, and thus, the occurrence of a human error such as inexecution of the reading operation is inhibited.

In the present embodiment, the component collation section 43 determines, on the basis of the remaining number information acquired by the remaining number information acquisition section 44, that the remaining number of electronic components C in the feeder 21 has become zero.

Besides, in the present embodiment, the component collation section 43 determines, on the basis of the retry count information acquired by the retry count acquisition section 37, that the remaining number of electronic components C in the feeder 21 has become zero.

If the remaining number of electronic components C in the feeder 21 has become zero, no electronic component C is supplied from the feeder 21 to the supplying position. Therefore, the nozzle 7 cannot hold an electronic component C. If the nozzle 7 cannot hold an electronic component C and it is determined that the nozzle 7 cannot hold an electronic component C even if the holding action of the nozzle 7 has been retried until the number of retries exceeds the threshold value, the component collation section 43 determines, on the basis of the retry count information acquired by the retry count acquisition section 37, that the remaining number of electronic components C in the feeder 21 has become zero.

Even if the holding action of the nozzle 7 has been retried until the number of retries exceeds the threshold value, there is a possibility that the reel 20 is not in a component shortage state. For example, owing to the attitude of the electronic component C in the supplying position, the attitude of the nozzle 7, the malfunction of the valve mechanism 31, the malfunction of the aspirator 29 or the like, there is a possibility that there occurs a situation where the nozzle 7 cannot hold the electronic component C even if the remaining number of electronic components C in the reel 20 is not zero. In the following description, a state where the nozzle 7 cannot hold an electronic component C owing to the attitude of the electronic component C in the supplying position, the attitude of the nozzle 7, the malfunction of the valve mechanism 31, the malfunction of the aspirator 29 or the like even though there remain electronic components C in the reel 20 (the feeder 21) is suitably designated as a simple holding error state.

In the occurrence of a simple holding error state, although an electronic component C remains in a reel 20, if it is determined on the basis of the retry count information acquired by the retry count acquisition section 37 that the number of retries is larger than the threshold value, there is a possibility that the component collation section 43 may determine that the remaining number of electronic components C in the reel 20 has become zero and output an "NG determination".

If a simple holding error state occurs, in order to resume the mounting operation, it is sufficient to settle the cause of the occurrence of the simple holding error state even without performing the component collation processing. Specifically, if a simple holding error state occurs, there is no need to exchange the reel 20 and there is no need to perform the component collation processing.

In the present embodiment, the operating device 51 capable of generating an operation signal for converting an "NG determination" of the component collation section 43 into an "OK determination" is provided. Even if the component collation section 43 outputs an "NG determination" due to a simple holding error state, the "NG determination" of the component collation section 43 can be converted into an "OK determination" by operating the operating device 51. Accordingly, without performing the component collation processing, the "NG determination" of the component collation section 43 can be converted into an "OK determination" merely by operating the operating device 51 after settling the cause of the occurrence of the simple holding error state. Thus, the control section 35 can start the mounting operation of the mounting apparatus 1.

In this manner, in the present embodiment, if the component collation section 43 outputs an "NG determination" when there is no need to exchange the reel 20 and to perform the component collation processing accompanying the exchange, the "NG determination" of the component collation section 43 is converted into an "OK determination" by operating the operating device 51, so that the mounting operation of the mounting apparatus 1 can be started (resumed). Since the mounting operation can be resumed without performing the component collation processing not necessary, degradation of the production efficiency can be suppressed.

On the other hand, if there occurs a reel 20 in a component shortage state and there occurs a situation where there is high necessity of exchanging the reel 20, there is a possibility that the operating device 51 may be operated due to a human error. Specifically, there is a possibility that the operating device 51 may be operated to convert an "NG determination" of the component collation section 43 into an "OK determination" even though it is necessary to perform the component collation processing (even though it is necessary to retain the "NG determination" of the component collation section 43). As a result, the false-mounting preventing function of the control system 200 is obstructed, and there is a possibility that a non-normal electronic component C may be mounted on the substrate P.

In the present embodiment, the operating device 51 is invalidated by the invalidation section 36 so that the operating device 51 cannot be operated when it is necessary to perform the component collation processing.

As described above, if there occurs a simple holding error state, the operating device 51 is operated to suppress the degradation of the production efficiency. Therefore, in the present embodiment, a condition for invalidating the operating device 51 is limited so that the suppression of the obstruction of the false-mounting preventing function due to the occurrence of a human error and the suppression of the degradation of the production efficiency can be both realized. In the present embodiment, the operating device 51 is invalidated on the basis of the remaining number information of electronic components C in the feeder 21.

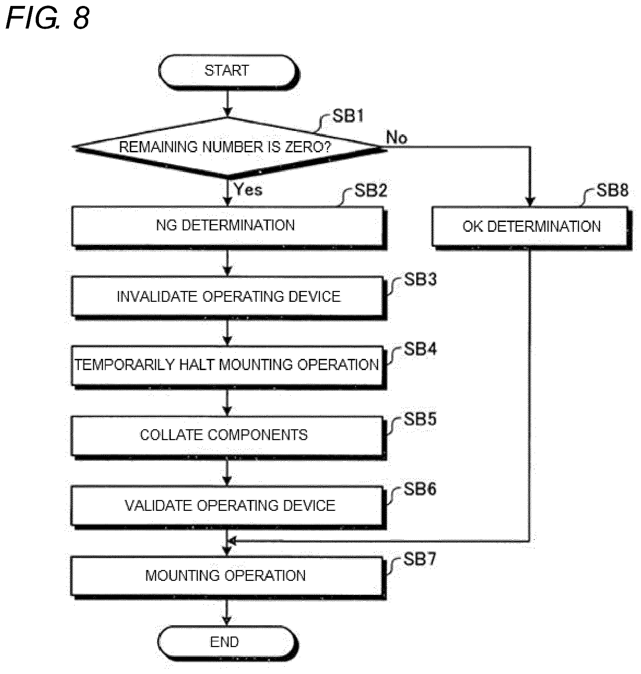

Now, an example in which the operating device 51 is invalidated if it is determined, on the basis of the remaining number information acquired by the remaining number information acquisition section 44, that the remaining number of electronic components C in the feeder 21 is zero will be described with reference to FIG. 8. FIG. 8 is a flowchart illustrating an example of a mounting method for an electronic component C by the electronic component mounting system 100 of the present embodiment.

When the mounting operation is started, the component collation section 43 collates the identification information for identifying an electronic component C of the feeder 21 of the supplying device 2 with the normal electronic component information to determine whether or not the electronic component C of the feeder 21 is a normal electronic component C (corresponding to step SA5 of FIG. 7). The control section 35 controls the mounting apparatus 1 on the basis of the determination result of the component collation section 43. If it is determined that the electronic component C of the feeder 21 is a normal electronic component C, namely, if the component collation section 43 outputs an "OK determination", the mounting operation is started (corresponding to step SA7 of FIG. 7). The control section 35 controls the mounting apparatus 1 so that the electronic component C supplied from the supplying device 2 can be held by the nozzle 7 to be mounted on a substrate P.

Through the mounting, the remaining number of electronic components C in the feeder 21 is reduced. The remaining number information corresponding to the remaining number of electronic components C in the feeder 21 is acquired by the remaining number information acquisition section 44.

The remaining number information acquisition section 44 determines whether or not the remaining number of electronic components C in the feeder 21 is zero (step SB1).

If it is determined that the remaining number is zero (namely, YES) in step SB1, the conversion section 45 converts the "OK determination" into an "NG determination". In other words, the conversion section 45 converts the "OK determination" of the component collation section 43 into an "NG determination" when the remaining number is zero (step SB2).

Besides, if it is determined that the remaining number is zero in step SB1, the invalidation section 36 invalidates the operating device 51 (step SB3).

Since the "OK determination" of the component collation section 43 has been converted into an "NG determination" in step SB2, the control section 35 (temporarily) halts the mounting operation of the mounting apparatus 1 (step SB4). In other words, if the determination result of the component collation section 43 is an "NG determination", the control section 35 halts the mounting operation of the mounting apparatus 1 through the processing performed by the conversion section 45.

After exchanging the reel 20 (the feeder 21) having been determined to have the remaining number of zero with a reel 20 in a brand-new state, the reading operation is carried out by an operator. The detection result of the reading device 27 is output to the identification information acquisition section 41. The component collation section 43 collates the identification information acquired by the identification information acquisition section 41 with the normal electronic component information acquired by the normal electronic component information acquisition section 42 to determine whether or not an electronic component C of the feeder 21 in a brand-new state is a normal electronic component C (step SB5).

If it is determined that the electronic component C of the feeder 21 is a normal electronic component C in step SB5, namely, if the component collation section 43 outputs an "OK determination", the invalidation section 36 cancels the invalidation of the operating device 51. In other words, the operating device 51 is validated (step SB6).

Besides, since the component collation section 43 outputs the "OK determination", the control section 35 starts (resumes) the mounting operation of the mounting apparatus 1 (step SB7). Thus, the mounting operation for the electronic component C of the feeder 21 in a brand-new state is started.

If it is determined that the remaining number is not zero (namely, NO) in step SB1, the determination result of the component collation section 43 is not changed, and the "OK determination" is retained (step SB8). The control section 35 continues the mounting operation of the mounting apparatus 1.

As described so far, in the present embodiment, since the operating device 51 capable of generating an operation signal for converting an "NG determination" of the component collation section 43 into an "OK determination" is provided, if the component collation section 43 outputs an "NG determination" due to the occurrence of a simple holding error state and the mounting operation of the mounting apparatus 1 is halted, the "NG determination" of the component collation section 43 is converted into an "OK determination" by operating the operating device 51 after settling the cause of the occurrence of the simple holding error state. Thus, a state where the mounting operation of the mounting apparatus 1 can be performed can be attained without performing the component collation processing. Since the mounting operation can be performed without performing the component collation processing, the degradation of the production efficiency can be suppressed.

Besides, since the invalidation section 36 for invalidating the operating device 51 on the basis of the remaining number information of electronic components C in the feeder 21 acquired by the remaining number information acquisition section 44 is provided, if the component collation section 43 outputs an "NG determination" due to the occurrence of a component shortage state and the mounting operation of the mounting apparatus 1 is halted, the operating device 51 is invalidated so that the component collation processing including the reading operation performed by an operator can be carried out. Besides, even if the operating device 51 is operated by an operator by mistake, the operating device 51 has been invalidated and hence the "NG determination" of the component collation section 43 can be retained. Therefore, the occurrence of a human error such as inexecution of the component collation processing can be suppressed.

In the present embodiment, if there occurs a component shortage state, the mounting operation of the mounting apparatus 1 is halted, and the invalidation section 36 makes the operating device 51 impossible to operate. Therefore, in order to start the mounting operation of the mounting apparatus 1 (namely, in order to cause the component collation section 43 to output an "OK determination"), the component collation processing including the reading operation should be unavoidably performed. If there occurs a component shortage state, there is high necessity of exchanging a reel 20 (a feeder 21). If the reel 20 is exchanged, it is necessary to cause the control system 200 to exhibit the false-mounting preventing function. Therefore, if there is a high possibility that the mounting operation of the mounting apparatus 1 is halted because of the occurrence of a component shortage state, the operating device 51 is invalidated to urge the component collation processing including the reading operation to be performed, and thus, the false-mounting preventing function of the control system 200 can be definitely exhibited.

In this manner, in the present embodiment, the false-mounting preventing function can be exhibited while suppressing the degradation of the production efficiency. Accordingly, a non-normal electronic component C can be prevented from being mounted on a substrate P, and as a result, a defective substrate is difficult to occur. Therefore, the quality degradation of products produced by using the electronic component mounting system 100 can be suppressed.

Incidentally, in the present embodiment, the operating device 51 is invalidated based on the remaining number information. The operating device 51 and the invalidation section 36 may be omitted. The conversion section 45 may convert an "OK determination" of the component collation section 43 into an "NG determination" on the basis of the remaining number information acquired by the remaining number information acquisition section 44. For example, if the remaining number is determined as zero, the conversion section 45 may convert an "OK determination" of the component collation section 43 into an "NG determination". The control section 35 halts the mounting operation of the mounting apparatus 1 if the determination result of the component collation section 43 is converted from the "OK determination" into the "NG determination" by the conversion section 45, and thus, a non-normal electronic component C can be inhibited from being mounted on a substrate P. When the component collation processing is performed and an "OK determination" is output from the component collation section 43, the control section 35 can start (resume) the mounting operation of the mounting apparatus 1.

In the present embodiment, the component collation section 43 determines, on the basis of the remaining number information acquired by the remaining number information acquisition section 44 and the retry count information acquired by the retry count acquisition section 37, whether or not there occurs a component shortage state. The remaining number information acquisition section 44 acquires the remaining number information corresponding to the remaining number of electronic components C in the supplying device 2 on the basis of the known information of the number of electronic components C held on a reel 20 in a brand-new state and the number of mounting actions output from the control section 35. The information on the number of electronic components C held on a reel 20 in a brand-new state (the known information) is provided from the supplier of the electronic components C to the manufacturer manufacturing products by using the electronic component mounting system 100. The number of electronic components C provided as the known information by the supplier is different from the number of electronic components C actually held on a reel 20 in a brand-new state in some cases. For example, the number of electronic components C provided as the known information is larger than the number of electronic components C actually held on a reel 20 in a brand-new state in some cases. Alternatively, there is a possibility that an electronic component C may have been dropped off from a reel 20 for some reason before attaching the reel 20 to a feeder 21. In such a case, the number of electronic components C provided as the known information may be smaller than the number of electronic components C actually held on the reel 20. In this manner, there is a possibility that the number of electronic components C provided as the known information may be different from the number of electronic components C actually held on the reel 20. As a result, even if it is determined on the basis of the remaining number information acquired by the remaining number information acquisition section 44 that there has occurred a component shortage state, there is a possibility that the component shortage state has not actually occurred.

On the other hand, even if it is determined on the basis of the number of retries acquired by the retry count acquisition section 37 that there has occurred a component shortage state, there is a possibility that the component shortage state may have not actually occurred. As described above, when a simple holding error state occurs, even if it is determined, on the basis of the retry count information acquired by the retry count acquisition section 37, that there has occurred a component shortage state, there is a possibility that the component shortage state may have not actually occurred.

Therefore, in the present embodiment, the component collation section 43 determines whether or not there has occurred a component shortage state on the basis of not only the remaining number information acquired by the remaining number information acquisition section 44 but also the retry count information acquired by the retry count acquisition section 37. Since the two information of the remaining number information and the retry count information are used for determining whether or not a component shortage state has occurred, the accuracy in the determination can be improved.

Incidentally, in the present embodiment, a reel 20 is exchanged when the remaining number of electronic components C held thereon is zero or the precedently determined threshold value. The reel 20 may be exchanged when the remaining number of electronic components C held thereon is larger than the threshold value. For example, one reel 20 is shared by a plurality of mounting apparatuses 1 in some cases. For example, with 1000 electronic components C held on a reel 20 in a brand-new state, 400 electronic components C are mounted on a substrate P by a first mounting apparatus 1, and thereafter, the reel 20 is taken out of a feeder 21 of the first mounting apparatus 1 to be attached to a feeder 21 of a second mounting apparatus 1 in some cases. In other words, a reel 20 in a used state is attached to a feeder 21 in step SA1 described above in some cases. When this reel 20 is attached to the feeder 21 of the second mounting apparatus 1, the reel 20 holds 600 electronic components C. Specifically, when the mounting operation of the first mounting apparatus 1 is completed, the remaining number of electronic components C in the reel 20 is 600. The remaining number information acquisition section 44 of the server 3 acquires this remaining number (namely, 600). Since the remaining number information acquisition section 44 grasps that the number of electronic components C remaining in the reel 20 attached in the second mounting apparatus 1 is 600, the component remaining number managing function for the second mounting apparatus 1 can be accurately performed. This also applies to embodiments described below.

### <Second Embodiment>

A second embodiment of the present invention will now be described. In the following description, like reference numerals are used to refer to like elements used in the electronic component mounting system 100 of the above-described first embodiment so as to simplify or omit the description.

In the electronic component mounting system 100 of the first embodiment described above, the operating device 51 is invalidated if it is determined that the remaining number of electronic components C in the feeder 21 is zero. In the present embodiment, the following example will be described: The operating device 51 is invalidated if it is determined that the remaining number of electronic components C in the feeder 21 is equal to or smaller than a first threshold value and that the number of retries is equal to or larger than a second threshold value, and the operating device 51 is not invalidated if it is determined that the remaining number of electronic components C in the feeder 21 is larger than the first threshold value.

In the present embodiment, if it is determined that the remaining number of electronic components C in the feeder 21 (the reel 20) is equal to or smaller than the first threshold value and that the number of retries is equal to or larger than the second threshold value, the invalidation section 36 invalidates the operating device 51. If it is determined that the remaining number of electronic components C in the feeder 21 is larger than the first threshold value, the invalidation section 36 does not invalidate the operating device 51. If it is determined that the remaining number of electronic components C in the feeder 21 is larger than the first threshold value, the invalidation section 36 does not invalidate the operating device 51 regardless of the number of retries.

In other words, if it is determined that the remaining number of electronic components C in the feeder 21 is equal to or smaller than the first threshold value and that the number of retries is equal to or larger than the second threshold value, the function of the operating device 51 is not exhibited. For example, if it is determined that the remaining number of electronic components C in the feeder 21 is equal to or smaller than the first threshold value and that the number of retries is equal to or larger than the second threshold value, the conversion section 45 converts an "OK determination" of the component collation section 43 into an "NG determination". In other words, if it is determined that the remaining number of electronic components C in the feeder 21 is equal to or smaller than the first threshold value and that the number of retries is equal to or larger than the second threshold value, the component collation section 43 outputs an "NG determination". If the operating device 51 is operated when the component collation section 43 outputs the "NG determination", since the operating device 51 is invalidated, the "NG determination" of the component collation section 43 is retained. Thus, a state where the mounting operation of the mounting apparatus 1 is not performed is retained.

On the other hand, if it is determined that the remaining number of electronic components C in the feeder 21 is larger than the first threshold value, the function of the operating device 51 is exhibited. For example, if it is determined that the remaining number of electronic components C in the feeder 21 is larger than the first threshold value, the component collation section 43 outputs an "NG determination", and when the operating device 51 is operated, the "NG determination" of the component collation section 43 is converted into an "OK determination" by the conversion section 45. Thus, a state where the mounting operation of the mounting apparatus 1 can be performed is attained.

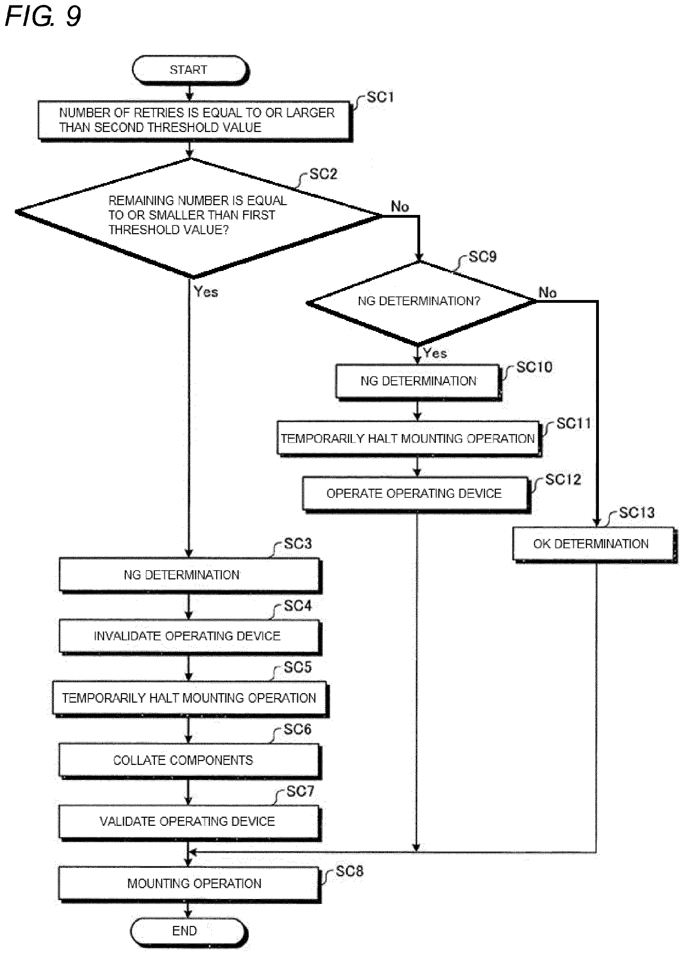

Now, an example of a mounting method for an electronic component C by using the electronic component mounting system 100 of the present embodiment will be described with reference to a flowchart of FIG. 9.

When the mounting operation is started, the component collation section 43 collates the identification information for identifying an electronic component of a feeder 21 of the supplying device 2 with the normal electronic component information to determine whether or not the electronic component C of the feeder 21 is a normal electronic component C (corresponding to step SA5 of FIG. 7). The control section 35 controls the mounting apparatus 1 on the basis of the determination result of the component collation section 43. If it is determined that the electronic component C of the feeder 21 is a normal electronic component C, namely, if the component collation section 43 outputs an "OK determination", the mounting operation is started (corresponding to step SA7 of FIG. 7). The control section 35 controls the mounting apparatus 1 so that the electronic component C supplied from the supplying device 2 can be held by the nozzle 7 to be mounted on a substrate P.

Through the mounting, the remaining number of electronic components C in the feeder 21 is reduced. The remaining number information corresponding to the remaining number of electronic components C in the feeder 21 is acquired by the remaining number information acquisition section 44.

In the mounting action, there is a possibility that a situation where the electronic component C is not held by the nozzle 7 may occur. If it is determined by the determination section 33 that the electronic component C has not been held by the nozzle 7, the control section 35 performs the retry of the holding action of the nozzle 7 (corresponding to step SA8 of FIG. 7).

The determination section 33 determines, on the basis of the detection result of the pressure sensor 33, whether or not the electronic component C has been held by the nozzle 7. The retry count acquisition section 37 acquires the retry count information corresponding to the number of retries of the holding action of the nozzle 7.

The retry count acquisition section 37 determines whether or not the number of retries is equal to or larger than the second threshold value. The second threshold value is, for example, 5. If it is determined that the number of retries is equal to or larger than the second threshold value, the retry count acquisition section 37 outputs a retry-over signal to the remaining number information acquisition section 44 (step SC1).

The remaining number information acquisition section 44 having acquired the retry-over signal determines whether or not the remaining number of electronic components C in the feeder 21 is equal to or smaller than the first threshold value (step SC2). The first threshold value is, for example, 50.

If it is determined that the remaining number is equal to or smaller than the first threshold value (namely, YES) in step SC2, the conversion section 45 converts an "OK determination" into an "NG determination". In other words, if it is determined that the remaining number is equal to or smaller than the first threshold value and that the number of retries is equal to or larger than the second threshold value, the conversion section 45 converts an "OK determination" of the component collation section 43 into an "NG determination" (step SC3).

Besides, if it is determined that the remaining number is equal to or smaller than the first threshold value and that the number of retries is equal to or larger than the second threshold value, the invalidation section 36 invalidates the operating device 51 (step SC4).

Since the "OK determination" of the component collation section 43 is converted into an "NG determination" in step SC2, the control section 35 (temporarily) halts the mounting operation of the mounting apparatus 1 (step SC5). In other words, if the determination result of the component collation section 43 is an "NG determination", the control section 35 halts the mounting operation of the mounting apparatus 1 through the processing performed by the conversion section 45.

If it is determined that the remaining number is equal to or smaller than the first threshold value and that the number of retries is equal to or larger than the second threshold value, there is a high possibility that the feeder 21 is in a component shortage state. After exchanging the feeder 21 with a feeder 21 in a brand-new state, the reading operation is performed by an operator. The detection result of the reading device 27 is output to the identification information acquisition section 41. The component collation section 43 collates the identification information acquired by the identification information acquisition section 41 with the normal electronic component information acquired by the normal electronic component information acquisition section 42 to determine whether or not an electronic component C of the feeder 21 in a brand-new state is a normal electronic component C (step SC6).

If it is determined that the electronic component C of the feeder 21 is a normal electronic component C in step SC6, namely, if the component collation section 43 outputs an "OK determination", the invalidation section 36 cancels the invalidation of the operating device 51. In other words, the operating device 51 is validated (step SC7).

Besides, when the component collation section 43 outputs the "OK determination", the control section 35 starts the mounting operation of the mounting apparatus 1 (step SC8). Thus, the mounting operation for the electronic component C of the feeder 21 in a brand-new state is started.

If it is determined that the remaining number is larger than the first threshold value (namely, NO) in step SC2, the conversion section 45 determines whether or not the determination result of the component collation section 43 obtained when the number of retries is equal to or larger than the second threshold value is an "NG determination" (step SC9). If it is determined that the remaining number is larger than the first threshold value, the invalidation section 36 does not invalidate the operating device 51.

If it is determined that the determination result of the component collation section 43 obtained when the number of retries is equal to or larger than the second threshold value is an "NG determination" (namely, YES) in step SC9, the determination result of the component collation section 43 is not changed but the "NG determination" is retained (step SC10).

If it is determined that the remaining number is larger than the first threshold value and that the number of retries is equal to or larger than the second threshold value, there is a high possibility that a simple holding error state has occurred. The control section 35 (temporarily) halts the mounting operation of the mounting apparatus 1 (step SC11). If a simple holding error state occurs, an operation to settle the cause of the occurrence of the simple holding error state is performed.

After completing the operation, the operating device 51 is operated by an operator (step SC12). The operating device 51 is not invalidated and can be operated by the operator. When the operating device 51 is operated, an operation signal for converting the "NG determination" of the component collation section 43 into an "OK determination" is generated.

The operation signal generated by operating the operating device 51 is output to the conversion section 45. The conversion section 45 converts the "NG determination" of the component collation section 43 into an "OK determination" on the basis of the operation signal generated by the operating device 51.

When the component collation section 43 outputs the "OK determination", the control section 35 starts the mounting operation of the mounting apparatus 1 (step SC8). Thus, after settling the simple holding error state, the mounting operation for the electronic component C is started.

In the present embodiment, when a simple holding error state occurs, neither the exchange of the feeder 21 nor the component collation processing including the reading operation is performed. Incidentally, when a simple holding error state occurs, in step SC12, the feeder 21 may be exchanged and the component collation processing including the reading operation may be performed. If the component collation section 43 outputs an "OK determination" in the component collation processing, the control section 35 may start the mounting operation of the mounting apparatus 1.

If it is determined that the determination result of the component collation section 43 obtained when the number of retries is equal to or larger than the second threshold value is an "OK determination" (namely, NO) in step SC9, the determination result of the component collation section 43 is not changed but the "OK determination" is retained (step SC13). The control section 35 performs the mounting operation of the mounting apparatus 1 (step SC8).

As described so far, in the present embodiment, it is determined, on the basis of the remaining number information acquired by the remaining number information acquisition section 44 and the retry count information acquired by the retry count acquisition section 37, whether or not the operating device 51 is invalidated.

There is a possibility that the number of electronic components C held on a reel 20 in a brand-new state provided as the known information is different from the number of electronic components C actually held on a reel 20 in a brand-new state. Even if it is determined, on the basis of the remaining number information acquired by the remaining number information acquisition section 44, that there has occurred a component shortage state, there is a possibility that the component shortage state has not actually occurred.

On the other hand, even if it is determined, on the basis of the number of retries acquired by the retry count acquisition section 37, that there has occurred a component shortage state, there is a possibility that the component shortage state has not actually occurred.

In this manner, there is a possibility that each of the determination result about the occurrence of a component shortage state obtained on the basis of the remaining number information acquired by the remaining number information acquisition section 44 and the determination result about the occurrence of a component shortage state obtained on the basis of the retry count information acquired by the retry count acquisition section 37 does not have sufficient accuracy.

In the present embodiment, in order to compensate the determination result obtained on the basis of the retry count information acquired by the retry count acquisition section 37, it is determined, on the basis of the remaining number information acquired by the remaining number information acquisition section 44, whether or not a component shortage state has occurred. Besides, in order to compensate the determination result obtained on the basis of the remaining number information acquired by the remaining number information acquisition section 44, it is determined, on the basis of the retry count information acquired by the retry count acquisition section 37, whether or not a component shortage state has occurred. In this manner, the accuracy in the determination result can be improved by using the two information of the retry count information and the remaining number information to determine whether or not a component shortage state has occurred.

In the present embodiment, if it is determined that the remaining number is equal to or smaller than the first threshold value and that the number of retries is equal to or larger than the second threshold value, it is determined that a component shortage state has substantially occurred, and the operating device 51 is invalidated. If it is determined that the remaining number is larger than the first threshold value, it is determined that a component shortage state has not occurred, and hence the operating device 51 is not invalidated. Thus, the degradation of the production efficiency can be prevented while reducing the occurrence of a defective substrate.

Incidentally, in the present embodiment, the operating device 51 is invalidated on the basis of the remaining number information and the retry count information. The operating device 51 and the invalidation section 36 may be omitted. The conversion section 45 may convert an "OK determination" of the component collation section 43 into an "NG determination" on the basis of the remaining number information and the retry count information. For example, the conversion section 45 may be operated to convert an "OK determination" of the component collation section 43 into an "NG determination" if it is determined that the remaining number is equal to or smaller than the first threshold value and that the number of retries is equal to or larger than the second threshold value, and may be operated not to convert an "OK determination" of the component collation section 43 into an "NG determination" if it is determined that the remaining number is larger than the first threshold value. The control section 35 halts the mounting operation of the mounting apparatus 1 if the determination result of the component collation section 43 is converted from an "OK determination" into an "NG determination" by the conversion section 45, and thus, a non-normal electronic component C can be inhibited from being mounted on a substrate P. Besides, the control section 35 can start (resume) the mounting operation of the mounting apparatus 1 when the component collation processing has been performed and the component collation section 43 outputs an "OK determination".

Incidentally, in the first and second embodiments described above, the identifier 24, the identifier 25 and the identifier 26 are described as bar codes. At least one of the identifier 24, the identifier 25 and the identifier 26 may be a wireless tag such as an RFID tag. For example, when a wireless tag is provided on one of the reel 20 and the feeder 21 with a communication device designated as a reader/writer provided on the other, the reel 20 and the feeder 21 are associated with each other. Alternatively, when a wireless tag is provided on one of the feeder 21 and the attaching portion 23 with a communication device designated as a reader/writer provided on the other, the feeder 21 and the attaching portion 23 can be associated with each other. If a wireless tag is used as the identifier 24, the identifier 25 or the identifier 26, the reading operation performed by using the reading device 27 is omitted in the component collation processing. The component collation section 43 can determine, on the basis of identification information acquired by using the wireless tag and the normal electronic component information defined by the production program, whether or not an electronic component C of the supplying device 2 is a normal electronic component C.

Further disclosed technology. In the following description, like reference numerals are used to refer to like elements used in the electronic component mounting system 100 of the first embodiment described above so as to simply or omit the description.

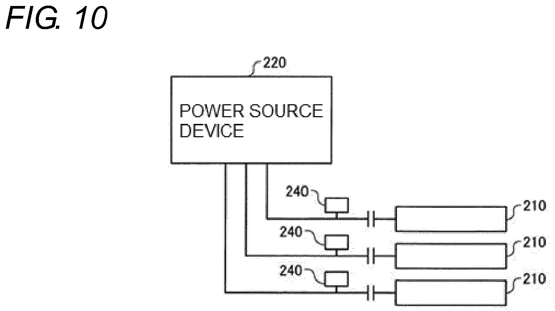

In the following an example in which the feeder 21 is an electric feeder will be described. FIG. 10 is a schematic diagram illustrating an example of an electric feeder 210. Power is supplied to the electric feeder 210 from a power source device 220. The electric feeder 21 includes an electric motor so as to supply a tape by using power generated by the electric motor.

The electric feeder 210 is attached to a feeder bank (or a collective exchange carriage). The electric feeder 210 is removably connected to the mounting apparatus 1. The electric feeder 210 is connected to the power source device 220 provided in the mounting apparatus 1. Each electric feeder 210 is provided with a feeder detecting device 240 for detecting a connection state of the electric feeder 210 to the mounting apparatus 1 (the power source device 220). The feeder detecting device 240 includes a current detecting device.

When the electric feeder 210 is connected to the mounting apparatus 1, a current flows between the power source device 220 and the electric feeder 210. When the electric feeder 210 is not connected to the mounting apparatus 1, no current flows between the power source device 220 and the electric feeder 210. The feeder detecting device 240 detects the current flowing between the power source device 220 and the electric feeder 210. The feeder detecting device 240 detects the connection state of the electric feeder 210 to the mounting apparatus 1 (the power source device 220) by detecting the current flowing between the power source device 220 and the electric feeder 210. When the mounting apparatus 1 is connected to the electric feeder 210, the feeder detecting device 240 detects a current. When the mounting apparatus 1 is not connected to the electric feeder 210, the feeder detecting device 240 does not detect a current.

The detection result of the feeder detecting device 240 is output to the invalidation section 36 and the conversion section 45. The invalidation section 36 invalidates the operating device 51 on the basis of the detection result of the feeder detecting device 240. Besides, the conversion section 45 converts an "OK determination" of the component collation section 43 into an "NG determination" if it is determined, on the basis of the detection result of the feeder detecting device 240, that the electric feeder 210 is in a non-connection state to the mounting apparatus 1.

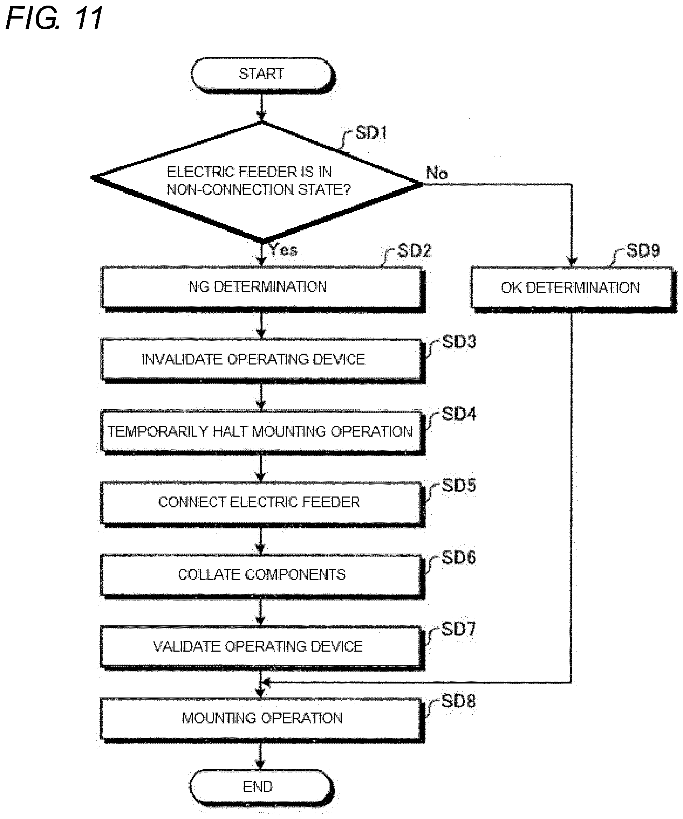

FIG. 11 is a flowchart illustrating an example of a mounting method for an electronic component C by using the electronic component mounting system 100.

The component collation section 43 collates the identification information identifying an electronic component C of the electric feeder 210 of the supply apparatus 2 with the normal electronic component information to determine whether or not the electronic component C of the electric feeder 210 is a normal electronic component C (corresponding to step SA5 of FIG. 7). The control section 35 controls the mounting apparatus 1 on the basis of the determination result of the component collation section 43. If it is determined that the electronic component C of the electric feeder 210 is a normal electronic component C, namely, if the component collation section 43 outputs an "OK determination", the mounting operation is started (corresponding to step SA7 of FIG. 11). The control section 35 controls the mounting apparatus 1 so that the electronic component C supplied from the electric feeder 210 can be held by the nozzle 7 to be mounted on a substrate P.

On the basis of the detection result of the feeder detecting device 240, it is determined whether or not the electric feeder 210 is in a non-connection state to the mounting apparatus 1 (step SD1).

If it is determined that the electric feeder 210 is in a non-connection state (namely, YES) in step SD1, the conversion section 45 converts the "OK determination" into an "NG determination". In other words, if the electric feeder 210 is in a non-connection state, the "OK determination" of the component collation section 43 is converted into an "NG determination" (step SD2).

Besides, if it is determined that the electric feeder 210 is in a non-connection state, the invalidation section 36 invalidates the operating device 51 (step SD3).

When the "OK determination" of the component collation section 43 is converted into the "NG determination" in step SD2, the control section 35 temporarily halts the mounting operation of the mounting apparatus 1 (step SD4). In other words, the control section 35 halts the mounting operation of the mounting apparatus 1 through the processing performed by the conversion section 45 if the determination result of the component collation section 43 is an "NG determination".

If it is determined that the electric feeder 210 is in a non-connection state, there is a high possibility that the electric feeder 210 is to be exchanged. The electric feeder 210 is exchanged with an electric feeder 210 in a brand-new state, and the electric feeder 210 in a brand-new state is connected to the mounting apparatus 1 (step SD5).

When the electric feeder 210 is connected to the mounting apparatus 1, the identification information of the electric feeder 210 is output to the identification information acquisition section 41. The component collation section 43 collates the identification information acquired by the identification information acquisition section 41 with the normal electronic component information acquired by the normal electronic component information acquisition section 42 to determine whether or not an electronic component C of the electric feeder 210 in a brand-new state is a normal electronic component C (step SD6).

If it is determined that the electronic component C of the electric feeder 210 is a normal electronic component C in step SD6, namely, if the component collation section 43 outputs an "OK determination", the invalidation section 36 cancels the invalidation of the operating device 51. In other words, the operating device 51 is validated (step SD7).

When the component collation section 43 outputs the "OK determination", the control section 35 starts (resumes) the mounting operation of the mounting apparatus 1 (step SD8). Thus, the mounting operation for the electronic component C of the electric feeder 210 in a brand-new state is started.

If it is determined that the electric feeder 210 is in a connection state to the mounting apparatus 1 (namely, NO) in step SD1, the determination result of the component collation section 43 is not changed but the "OK determination" is retained (step SD9). The control section 35 continues the mounting operation of the mounting apparatus 1.

As described so far, it is determined, on the basis of the detection result for the connection state of the electric feeder 210, whether or not there is a high possibility that the electric feeder 210 is to be exchanged, and if it is determined that there is a high possibility of the exchange, the component collation processing is performed. Accordingly, the degradation of the production efficiency can be suppressed while inhibiting a non-normal electronic component C from being mounted on the substrate P.

Incidentally, the operating device 51 is invalidated on the basis of the connection state of the electric feeder 210 detected by the feeder detecting device 240. The operating device 51 and the invalidation section 36 may be omitted. The conversion section 45 may convert an "OK determination" of the component collation section 43 into an "NG determination" on the basis of the detection result of the feeder detecting device 240. For example, the conversion section 45 may convert an "OK determination" of the component collation section 43 into an "NG determination" if it is determined, on the basis of the detection result of the feeder detecting device 240, that the electric feeder 210 is in a non-connection state. The control section 35 halts the mounting operation of the mounting apparatus 1 if the determination result of the component collation section 43 is converted from an "OK determination" into an "NG determination" by the conversion section 45, and thus, a non-normal electronic component C can be inhibited from being mounted on the substrate P. Besides, the control section 35 can start (resume) the mounting operation of the mounting apparatus 1 when the component collation processing has been performed and the component collation section 43 outputs an "OK determination".

## Claims

1. An electronic component mounting system (100), comprising:
a supplying device (2) capable of supplying an electronic component (C);
a mounting apparatus (1) that includes a holding member (7) for removably holding the electronic component (C) and is capable of mounting the electronic component (C) of the supplying device (2) on a substrate (P) by holding the electronic component (C) with the holding member (7);
an identification information acquisition section (41) that is configured to acquire identification information for identifying the electronic component (C) of the supplying device (2);
a normal electronic component information acquisition section (42) that is configured to acquire normal electronic component information corresponding to an electronic component (C) to be mounted on the substrate;
a component collation section (43) that is configured
i. to collate the identification information with the normal electronic component information (42) to determine whether or not the electronic component (C) of the supplying device (2) is the electronic component (C) to be mounted on the substrate,
ii. to output a positive determination when the electronic component (C) of the supplying device (2) is the electronic component (C) to be mounted on the substrate (P), and
iii. to output a negative determination when the electronic component (C) of the supplying device (2) is not the electronic component (C) to be mounted on the substrate (P);
a control section (35) that is configured to control the mounting apparatus (1) on the basis of a determination result of the component collation section (43);
a remaining number information acquisition section (44) that is configured to acquire remaining number information corresponding to the remaining number of electronic components (C) in the supplying device (2);
**characterized in that** the system (100) further comprises:
a holding state sensor (32) that is configured to detect a holding state of the holding member (7) for the electronic component (C);
a determination section (33) that is configured to determine, on the basis of a detection result of the holding state sensor (32), whether or not the electronic component (C) has been held by the holding member (7);
and
a retry count acquisition section (37) that is configured to acquire retry count information corresponding to the number of retries of a holding action of the holding member (7) performed when the determination section (33) determines that the electronic component (C) has not been held by the holding member (7),
wherein the component collation section (43) is configured to determine that the remaining number of electronic components (C) has become zero, when the number of retries exceeds a threshold value, on the basis of the retry count information acquired by the retry count acquisition section (37),
and wherein the component collation section (43) is configured to output the negative determination when the component collation section (43) determines that the remaining number of the electronic components (C) based on the retry count information acquired by the retry count acquisition section (37) has become zero;
wherein the system (100) further comprises:
an operating device (51) capable of generating an operation signal for converting the negative determination output from the component collation section (43) into the positive determination when the operating device (51) is operated by an operator; and
an invalidation section (36) capable of invalidating the generation of the operation signal by the operating device (51) on the basis of the acquired remaining number information.

2. The electronic component mounting system according to claim 1, wherein the invalidation section (36) is configured to invalidate the operating device (51) when the remaining number is zero.

3. The electronic component mounting system according to claim 1, wherein the electronic component mounting system (100) further comprises a conversion section (45) that is configured to convert the positive determination of the component collation section (43) into the negative determination when the remaining number is zero.

4. The electronic component mounting system according to claim 1, wherein the invalidation section (36) is configured to invalidate the operating device if the remaining number is equal to or smaller than a first threshold value and the number of retries is equal to or larger than a second threshold value, and is configured not to invalidate the operating device (51) if the remaining number is larger than the first threshold value.

5. The electronic component mounting system according to claim 3, further comprising a conversion section (45) that is configured to convert the positive determination of the component collation section (43) into the negative determination when the remaining number is equal to or smaller than the first threshold value and the number of retries is equal to or larger than the second threshold value.

6. The electronic component mounting system according to any one of claims 1 to 4, wherein the control section (35) is configured to halt a mounting operation of the mounting apparatus (1) when the determination result of the component collation section (43) is a negative determination.

7. An electronic component mounting method, comprising:
performing collation of identification information for identifying an electronic component (C) of a supplying device (2) with normal electronic component information corresponding to an electronic component (C) to be mounted on a substrate (P) to make a determination whether or not the electronic component (C) of the supplying device (2) is the electronic component (C) to be mounted on the substrate (P), and
outputting a positive determination when the electronic component (C) of the supplying device (2) is the electronic component (C) to be mounted on the substrate (P), and outputting a negative determination when the electronic component (C) of the supplying device (2) is not the electronic component (C) to be mounted on the substrate (P);
mounting the electronic component (C) supplied from the supplying device (2) on a substrate (P), on the basis of a result of the determination, by holding the electronic component (C) with a holding member (7) of a mounting apparatus (1);
acquiring remaining number information corresponding to the remaining number of electronic components (C) in the supplying device (2); and
**characterized by**
determining, on the basis of a detection result, whether or not the electronic component (C) has been held by the holding member (7);
acquiring retry count information corresponding to the number of retries of a holding action of the holding member (7) performed when determining that the electronic component (C) has not been held by the holding member (7);
and determining that the remaining number of electronic components (C) has become zero, when the number of retries exceeds a threshold value, on the basis of the retry count information,
also outputting the negative determination when the remaining number of the electronic component (C) based on the determined remaining number information has become zero; and
invalidating, on the basis of the remaining number information, an operating device (51) capable of generating an operation signal for converting the negative determination of the collation into the positive determination when operated by an operator.

## Patentansprüche

1. Elektronikkomponenten-Montagesystem (100), umfassend:
eine Zuführeinrichtung (2), welche dazu in der Lage ist, eine Elektronickomponente (C) zuzuführen;
eine Montagevorrichtung (1), welche ein Halteglied (7) zum lösbaren Halten der Elektronikkomponente (C) umfasst und dazu in der Lage ist, die Elektronikkomponente (C) der Zuführeinrichtung (2) durch Halten der Elektronikkomponente (C) mit dem Halteglied (7) auf einem Substrat (P) zu montieren;
einen Identifikationsinformations-Akquisitionsabschnitt (41), welcher dazu ausgebildet ist, Identifikationsinformation zum Identifizieren der Elektronikkomponente (C) der Zuführeinrichtung (2) zu akquirieren;
einen Normalelektronikkomponenteninformations-Akquisitionsabschnitt (42), welcher dazu ausgebildet ist, eine Normalelektronikkomponenteninformation zu akquirieren, welche zu einer Elektronikkomponente (C) korrespondiert, die auf dem Substrat zu montieren ist;
einen Komponenten-Vergleichsabschnitt (43), welcher zu Folgendem ausgebildet ist:
i. Vergleichen der Identifikationsinformation mit der Normalelektronikkomponenteninformation (42), um zu bestimmen, ob oder ob nicht die Elektronikkomponente (C) der Zuführeinrichtung (2) die auf dem Substrat zu montierende Elektronikkomponente (C) ist,
ii. Ausgeben einer Positivbestimmung, wenn die Elektronikkomponente (C) der Zuführeinrichtung (2) die auf dem Substrat (P) zu montierende Elektronikkomponente (C) ist, und
iii. Ausgeben einer Negativbestimmung, wenn die Elektronikkomponente (C) der Zuführeinrichtung (2) nicht die auf dem Substrat (P) zu montierende Elektronikkomponente (C) ist;
einen Steuerabschnitt (35), welcher dazu ausgebildet ist, die Montagevorrichtung (1) auf der Basis eines Bestimmungsergebnisses des Komponenten-Vergleichsabschnitts (43) zu steuern;
einen Restzahlinformations-Akquisitionsabschnitt (44), welcher dazu ausgebildet ist, eine Restzahlinformation zu akquirieren, welche zu der Restzahl von Elektronikkomponenten (C) in der Zuführeinrichtung (2) korrespondiert;
**dadurch gekennzeichnet, dass** das System (100) ferner umfasst:
einen Haltezustandssensor (32), welcher dazu ausgebildet ist, einen Haltezustand des Halteglieds (7) für die Elektronikkomponente (C) zu detektieren;
einen Bestimmungsabschnitt (33), welcher dazu ausgebildet ist, auf der Basis eines Detektionsergebnisses des Haltezustandssensors (32) zu bestimmen, ob oder ob nicht die Elektronikkomponente (C) von dem Halteglied (7) gehalten worden ist;
und
einen Wiederholungsversuchszählungs-Akquisitionsabschnitt (37), welcher dazu ausgebildet ist, eine Wiederholungsversuchszählungsinformation zu akquirieren, welche zu der Anzahl von Wiederholungsversuchen einer Halteaktion des Halteglieds (7) korrespondiert, die durchgeführt werden, wenn der Bestimmungsabschnitt (33) bestimmt, dass die Elektronikkomponente (C) nicht von dem Halteglied (7) gehalten worden ist,
wobei der Komponenten-Vergleichsabschnitt (43) dazu ausgebildet ist, auf der Basis der von dem Wiederholungsversuchszählungs-Akquisitionsabschnitt (37) akquirierten Wiederholungsversuchszählungsinformation zu bestimmen, dass die Restzahl von Elektronikkomponenten (C) zu Null geworden ist, wenn die Anzahl von Wiederholungsversuchen einen Schwellenwert überschreitet,
und wobei der Komponenten-Vergleichsabschnitt (43) dazu ausgebildet ist, die Negativbestimmung auszugeben, wenn der Komponenten-Vergleichsabschnitt (43) bestimmt, dass die Restzahl der Elektronikkomponenten (C) basierend auf der von dem Wiederholungsversuchszählungs-Akquisitionsabschnitt (37) akquirierten Wiederholungsversuchszählungsinformation zu Null geworden ist;
wobei das System (100) ferner umfasst:
eine Betätigungseinrichtung (51), welche dazu in der Lage ist, ein Betätigungssignal zu generieren zum Konvertieren der von dem Komponenten-Vergleichsabschnitt (43) ausgegebenen Negativbestimmung in die Positivbestimmung, wenn die Betätigungseinrichtung (51) von einer Bedienperson betätigt wird; und
einen Invalidierungsabschnitt (36), welcher dazu in der Lage ist, die Generierung des Betätigungssignals mittels der Betätigungseinrichtung (51) auf der Basis der akquirierten Restzahlinformation zu invalidieren.

2. Elektronikkomponenten-Montagesystem nach Anspruch 1, wobei der Invalidierungsabschnitt (36) dazu ausgebildet ist, die Betätigungseinrichtung (51) zu invalidieren, wenn die Restzahl Null ist.

3. Elektronikkomponenten-Montagesystem nach Anspruch 1, wobei das Elektronikkomponenten-Montagesystem (100) ferner umfasst: einen Konvertierungsabschnitt (45), welcher dazu ausgebildet ist, die Positivbestimmung des Komponenten-Vergleichsabschnitts (43) in die Negativbestimmung zu konvertieren, wenn die Restzahl Null ist.

4. Elektronikkomponenten-Montagesystem nach Anspruch 1, wobei der Invalidierungsabschnitt (36) dazu ausgebildet ist, die Betätigungseinrichtung zu invalidieren, wenn die Restzahl gleich oder kleiner ist als ein erster Schwellenwert und die Anzahl von Wiederholungsversuchen gleich oder größer ist als ein zweiter Schwellenwert, und dazu ausgebildet ist, die Betätigungseinrichtung (51) nicht zu invalidieren, wenn die Restzahl größer als der erste Schwellenwert ist.

5. Elektronikkomponenten-Montagesystem nach Anspruch 3, ferner umfassend einen Konvertierungsabschnitt (45), welcher dazu ausgebildet ist, die Positivbestimmung des Komponenten-Vergleichsabschnitts (43) in die Negativbestimmung zu konvertieren, wenn die Restzahl gleich oder kleiner ist als der erste Schwellenwert und die Anzahl von Wiederholungsversuchen gleich oder größer ist als der zweite Schwellenwert.

6. Elektronikkomponenten-Montagesystem nach einem der Ansprüche 1 bis 4, wobei der Steuerabschnitt (35) dazu ausgebildet ist, eine Montageoperation der Montagevorrichtung (1) anzuhalten, wenn das Bestimmungsergebnis des Komponenten-Vergleichsabschnitts (43) eine Negativbestimmung ist.

7. Elektronikkomponenten-Montageverfahren, welches umfasst:
Durchführen eines Vergleichs von Identifikationsinformation zum Identifizieren einer Elektronikkomponente (C) einer Zuführeinrichtung (2) mit einer Normalelektronikkomponenteninformation, welche zu einer Elektronikkomponente (C) korrespondiert, die auf einem Substrat (P) zu montieren ist, um eine Bestimmung durchzuführen, ob oder ob nicht die Elektronikkomponente (C) der Zuführeinrichtung (2) die auf dem Substrat (P) zu montierende Elektronikkomponente (C) ist, und
Ausgeben einer Positivbestimmung, wenn die Elektronikkomponente (C) der Zuführeinrichtung (2) die auf dem Substrat (P) zu montierende Elektronikkomponente (C) ist, und Ausgeben einer Negativbestimmung, wenn die Elektronikkomponente (C) der Zuführeinrichtung (2) nicht die auf dem Substrat (P) zu montierende Elektronikkomponente (C) ist;
Montieren der von der Zuführeinrichtung (2) zugeführten Elektronickomponente (C) auf einem Substrat (P) auf der Basis eines Ergebnisses der Bestimmung, durch Halten der Elektronikkomponente (C) mit einem Halteglied (7) einer Montagevorrichtung (1);
Akquirieren einer Restzahlinformation, welche zu der Restzahl von Elektronikkomponenten (C) in der Zuführeinrichtung (2) korrespondiert; und
welches **gekennzeichnet ist durch** Folgendes:
Bestimmen, auf der Basis eines Detektionsergebnisses, ob oder ob nicht die Elektronikkomponente (C) von dem Halteglied (7) gehalten worden ist;
Akquirieren einer Wiederholungsversuchszählungsinformation, welche zu der Anzahl von Wiederholungsversuchen einer Halteaktion des Halteglieds (7) korrespondiert, die durchgeführt werden, wenn bestimmt wird, dass die Elektronikkomponente (C) nicht von dem Halteglied (7) gehalten worden ist;
und Bestimmen, auf der Basis der Wiederholungsversuchszählungsinformation, dass die Restzahl von Elektronikkomponenten (C) zu Null geworden ist, wenn die Anzahl von Wiederholungsversuchen einen Schwellenwert überschreitet,
ferner Ausgeben der Negativbestimmung, wenn die Restzahl der Elektronikkomponenten (C) basierend auf der bestimmten Restzahlinformation zu Null geworden ist; und
Invalidieren, auf der Basis der Restzahlinformation, einer Betätigungseinrichtung (51), welche dazu in der Lage ist, ein Betätigungssignal zu generieren zum Konvertieren der Negativbestimmung des Vergleichs in die Positivbestimmung bei Betätigung durch eine Bedienperson.

## Revendications

1. Structure de montage de composant électronique (100), comprenant :
un dispositif de fourniture (2) en mesure de fournir un composant électronique (C) ;
un appareil de montage (1) qui inclut un élément de maintien (7) pour maintenir de manière amovible le composant électronique (C), et qui est en mesure de monter le composant électronique (C) du dispositif de fourniture (2) sur un substrat (P) en maintenant le composant électronique (C) avec l'élément de maintien (7) ;
une section d'acquisition d'informations d'identification (41) qui est configurée de manière à acquérir des informations d'identification pour identifier le composant électronique (C) du dispositif de fourniture (2) ;
une section d'acquisition d'informations de composant électronique normal (42) qui est configurée de manière à acquérir des informations de composant électronique normal correspondant à un composant électronique (C) à monter sur le substrat ;
une section de collationnement de composant (43) qui est configurée de manière à :
i. collationner les informations d'identification avec les informations de composant électronique normal (42) en vue de déterminer si oui le composant électronique (C) du dispositif de fourniture (2) est ou non le composant électronique (C) à monter sur le substrat ;
ii. fournir en sortie une détermination positive lorsque le composant électronique (C) du dispositif de fourniture (2) est le composant électronique (C) à monter sur le substrat (P) ; et
iii. fournir en sortie une détermination négative lorsque le composant électronique (C) du dispositif de fourniture (2) n'est pas le composant électronique (C) à monter sur le substrat (P) ;
une section de commande (35) qui est configurée de manière à commander l'appareil de montage (1) sur la base d'un résultat de détermination de la section de collationnement de composant (43) ;
une section d'acquisition d'informations de nombre restant (44) qui est configurée de manière à acquérir des informations de nombre restant correspondant au nombre restant de composants électroniques (C) dans le dispositif de fourniture (2) ;
**caractérisé en ce que** la structure de montage (100) comprend en outre :
un capteur d'état de maintien (32) qui est configuré de manière à détecter un état de maintien de l'élément de maintien (7) pour le composant électronique (C) ;
une section de détermination (33) qui est configurée de manière à déterminer, sur la base d'un résultat de détection du capteur d'état de maintien (32), si le composant électronique (C) a été maintenu ou non par l'élément de maintien (7) ; et
une section d'acquisition de comptage de nouveaux essais (37) qui est configurée de manière à acquérir des informations de comptage de nouveaux essais correspondant au nombre de nouveaux essais d'une action de maintien de l'élément de maintien (7) mise en œuvre lorsque la section de détermination (33) détermine que le composant électronique (C) n'a pas été maintenu par l'élément de maintien (7) ;
dans laquelle la section de collationnement de composant (43) est configurée de manière à déterminer que le nombre restant de composants électroniques (C) est devenu nul, lorsque le nombre de nouveaux essais dépasse une valeur de seuil, sur la base des informations de comptage de nouveaux essais acquises par la section d'acquisition de comptage de nouveaux essais (37) ; et
dans laquelle la section de collationnement de composant (43) est configurée de manière à fournir en sortie la détermination négative lorsque la section de collationnement de composant (43) détermine que le nombre restant de composants électroniques (C) basé sur les informations de comptage de nouveaux essais acquises par la section d'acquisition de comptage de nouveaux essais (37) est devenu nul ;
dans laquelle la structure de montage (100) comprend en outre :
un dispositif d'exploitation (51) en mesure de générer un signal d'opération pour convertir la détermination négative, fournie en sortie à partir de la section de collationnement de composant (43), en la détermination positive, lorsque le dispositif d'exploitation (51) est exploité par un opérateur ; et
une section d'invalidation (36) en mesure d'invalider la génération du signal d'opération par le dispositif d'exploitation (51), sur la base des informations de nombre restant acquises.

2. Structure de montage de composant électronique selon la revendication 1, dans laquelle la section d'invalidation (36) est configurée de manière à invalider le dispositif d'exploitation (51) lorsque le nombre restant est nul.

3. Structure de montage de composant électronique selon la revendication 1, dans laquelle la structure de montage de composant électronique (100) comprend en outre une section de conversion (45) qui est configurée de manière à convertir la détermination positive de la section de collationnement de composant (43), en la détermination négative, lorsque le nombre restant est nul.

4. Structure de montage de composant électronique selon la revendication 1, dans laquelle la section d'invalidation (36) est configurée de manière à invalider le dispositif d'exploitation si le nombre restant est égal ou inférieur à une première valeur de seuil, et si le nombre de nouveaux essais est égal ou supérieur à une seconde valeur de seuil, et est configurée de manière à ne pas invalider le dispositif d'exploitation (51) si le nombre restant est supérieur à la première valeur de seuil.

5. Structure de montage de composant électronique selon la revendication 3, comprenant en outre une section de conversion (45) qui est configurée de manière à convertir la détermination positive de la section de collationnement de composant (43), en la détermination négative, lorsque le nombre restant est égal ou inférieur à la première valeur de seuil, et lorsque le nombre de nouveaux essais est égal ou supérieur à la seconde valeur de seuil.

6. Structure de montage de composant électronique selon l'une quelconque des revendications 1 à 4, dans laquelle la section de commande (35) est configurée de manière à mettre fin à une opération de montage de l'appareil de montage (1) lorsque le résultat de détermination de la section de collationnement de composant (43) est une détermination négative.

7. Procédé de montage de composant électronique, comprenant les étapes ci-dessous consistant à :
mettre en œuvre un collationnement d'informations d'identification, pour identifier un composant électronique (C) d'un dispositif de fourniture (2), avec des informations de composant électronique normal correspondant à un composant électronique (C) à monter sur un substrat (P), pour effectuer une détermination visant à déterminer si le composant électronique (C) du dispositif de fourniture (2) est ou non le composant électronique (C) à monter sur le substrat (P) ; et
fournir en sortie une détermination positive lorsque le composant électronique (C) du dispositif de fourniture (2) est le composant électronique (C) à monter sur le substrat (P), et fournir en sortie une détermination négative lorsque le composant électronique (C) du dispositif de fourniture (2) n'est pas le composant électronique (C) à monter sur le substrat (P) ;
monter le composant électronique (C) fourni à partir du dispositif de fourniture (2) sur un substrat (P), sur la base d'un résultat de la détermination, en maintenant le composant électronique (C) avec un élément de maintien (7) d'un appareil de montage (1) ;
acquérir des informations de nombre restant correspondant au nombre restant de composants électroniques (C) dans le dispositif de fourniture (2) ; et
**caractérisé par** les étapes ci-dessous consistant à :
déterminer, sur la base d'un résultat de détection, si le composant électronique (C) a été ou non maintenu par l'élément de maintien (7) ;
acquérir des informations de comptage de nouveaux essais correspondant au nombre de nouveaux essais d'une action de maintien de l'élément de maintien (7) mise en œuvre dans le cadre de la détermination selon laquelle le composant électronique (C) n'a pas été maintenu par l'élément de maintien (7) ; et
déterminer que le nombre restant de composants électroniques (C) est devenu nul, lorsque le nombre de nouveaux essais dépasse une valeur de seuil, sur la base des informations de comptage de nouveaux essais ;
fournir en sortie, également, la détermination négative, lorsque le nombre restant de composants électroniques (C) basé sur les informations de nombre restant déterminées est devenu nul ; et
invalider, sur la base des informations de nombre restant, un dispositif d'exploitation (51) en mesure de générer un signal d'opération pour convertir la détermination négative du collationnement, en la détermination positive, lorsqu'il est exploité par un opérateur.
